# EUROPEAN PATENT SPECIFICATION

(11) **EP 4 207 993 B1**
(45) Date of publication and mention of the grant of the patent: **10.09.2025**
(21) Application number: 22215052.6
(22) Date of filing: 20.12.2022
(51) Int. Cl.: H10K 85/60, H10K 50/13

(54) **LIGHT EMITTING DEVICE AND LIGHT EMITTING DISPLAY DEVICE INCLUDING THE SAME**
LICHTEMITTIERENDE VORRICHTUNG UND LICHTEMITTIERENDE ANZEIGEVORRICHTUNG DAMIT
DISPOSITIF ÉLECTROLUMINESCENT ET DISPOSITIF D'AFFICHAGE ÉLECTROLUMINESCENT LE COMPRENANT

(30) Priority: 31.12.2021 KR 20210194798
(43) Date of publication of application: 05.07.2023
(73) Proprietor: LG Display Co., Ltd., Seoul 07336 (KR)
(72) Inventor: SONG, Wook, Paju-si (KR); CHO, Myeong Seon, Paju-si (KR); PARK, Sae Mi, Paju-si (KR); KIM, Jung Keun, Paju-si (KR); KIM, Do Han, Paju-si (KR); KIM, Byung Soo, Paju-si (KR); KANG, Hye Seung, Paju-si (KR)
(74) Representative: Ter Meer Steinmeister & Partner

(56) References cited:
- US-A1- 2020 212 312

## Description

### BACKGROUND OF THE INVENTION

### Field of the Invention

The present invention relates to a light emitting device, and more particularly to a light emitting device that is capable of improving efficiency of emission of white light, securing the stability over time and thus prolonging the lifespan by improving the exciton efficiency for each color equally in the phosphorescent stack based on the change of the materials of the hole transport layer and the green light emitting layer of the phosphorescent stack adjacent to the blue stack, and a light emitting display device including the same.

### Discussion of the Related Art

Recently, a light emitting display device that does not require a separate light source and has a light emitting device in a display panel without a separate light source to make the display device compact and realize clear color has been considered a competitive application.

Meanwhile, light emitting devices currently used in light emitting display devices require higher efficiency in order to realize desired image quality, and are preferably implemented in the form of a plurality of stacks.

In addition, in response to the demand for higher image quality, a display device requires high color purity. For this purpose, research is being conducted on improving color purity and improving luminance of all colors by providing a single light emitting layer for each stack.

However, when a single light emitting layer is provided for each stack in order to improve color purity, there is a problem in that the driving voltage is increased due to the large number of stacks.

US 2020/0212312 Al relates to an OLED comprising an EML which includes a first host (carbazole-based compound), a second host (triazine-based compound) and a first dopant.

### SUMMARY OF THE INVENTION

Accordingly, the present invention is directed to a light emitting device and a light emitting display device including the same that substantially obviate one or more problems due to the limitations and disadvantages of the related art.

It is an object of the present invention to provide a light emitting device that is capable of securing high efficiency and a longer lifespan without increasing the driving voltage even in a structure having multiple stacks including a single light emitting layer for each stack in order to increase color purity, and a light emitting display device including the same.

Additional advantages, objects, and features of the invention will be set forth in part in the description which follows and in part will become apparent to those having ordinary skill in the art upon examination of the following, or may be learned from practice of the invention. The objectives and other advantages of the invention may be realized and attained by the structure particularly pointed out in the written description and claims hereof as well as the appended drawings.

The light emitting device of the present invention is capable of improving color purity and luminance, reducing a material driving voltage, and exhibiting a longer lifespan by changing the configuration in the green stack.

To achieve these objects and other advantages and in accordance with the purpose of the invention, as embodied and broadly described herein, a light emitting device includes a first electrode and a second electrode facing each other and a light emitting unit including a p-type charge generation layer, a hole transport layer, and a green light emitting layer that are sequentially stacked, wherein the green light emitting layer includes a triazine-based compound as a host, and a phosphorescent dopant as defined in claim 1.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIG. 1 is a cross-sectional view illustrating a light emitting device according to an embodiment of the present invention;
FIG. 2 is an energy band diagram for each layer of a green stack according to an embodiment of a light emitting device of the present invention;
FIG. 3 is a cross-sectional view illustrating light emitting devices used in first and second experimental example groups;
FIG. 4 is a graph showing the emission spectrum of the first experimental example group;
FIG. 5 is a graph showing the emission spectrum of the second experimental example group;
FIGS. 6A and 6B are diagrams showing the configuration of phosphorescent stacks according to third and fourth experimental examples;
FIG. 7 is a cross-sectional view illustrating light emitting devices according to fifth to seventh experimental examples of the present invention;
FIG. 8 is a graph showing white emission spectra of light emitting devices according to the fifth to seventh experimental examples of FIG. 7;
FIG. 9 is a cross-sectional view showing a light emitting device according to another embodiment of the present invention; and
FIG. 10 is a cross-sectional view illustrating a light emitting display device using the light emitting device of the present invention according to an exemplary embodiment.

### DETAILED DESCRIPTION OF THE INVENTION

Reference will now be made in detail to preferred embodiments of the present invention, examples of which are illustrated in the accompanying drawings. Wherever possible, the same reference numbers will be used throughout the drawings to refer to the same or like parts. In the following description of the present invention, detailed descriptions of known functions and configurations incorporated herein will be omitted when the same may obscure the subject matter of the present invention. In addition, the names of elements used in the following description are selected in consideration of clarity of description of the specification, and may differ from the names of elements of actual products.

The shape, size, ratio, angle, number, and the like shown in the drawings to illustrate various embodiments of the present invention are merely provided for illustration, and the invention is not limited to the content shown in the drawings. Wherever possible, the same reference numbers will be used throughout the drawings to refer to the same or like parts. In the following description, detailed descriptions of technologies or configurations related to the present invention may be omitted so as to avoid unnecessarily obscuring the subject matter of the present invention. When terms such as "including", "having", and "comprising" are used throughout the specification, an additional component may be present, unless "only" is used. A component described in a singular form encompasses a plurality thereof unless particularly stated otherwise.

The components included in the embodiments of the present invention should be interpreted to include an error range, even if there is no additional particular description thereof.

In describing the variety of embodiments of the present invention, when terms describing positional relationships, such as "on", "above", "under", and "next to", are used, at least one intervening element may be present between the two elements, unless "immediately" or "directly" is also used.

In describing the variety of embodiments of the present invention, when terms related to temporal relationships, such as "after", "subsequently", "next", and "before", are used, the non-continuous case may be included, unless "immediately" or "directly" is also used.

In describing the variety of embodiments of the present invention, terms such as "first" and "second" may be used to describe a variety of components, but these terms only aim to distinguish the same or similar components from one another. Accordingly, throughout the specification, a "first" component may be the same as a "second" component within the technical concept of the present invention, unless specifically mentioned otherwise.

Features of various embodiments of the present disclosure may be partially or completely coupled to or combined with each other, and may be variously inter-operated with each other and driven technically. The embodiments of the present disclosure may be carried out independently from each other, or may be carried out together in an interrelated manner.

As used herein, the term "doped" means that, in a material that accounts for most of the weight of a layer, a material (for example, n-type and p-type materials, or organic and inorganic substances) having physical properties different from the material that occupies most of the weight ratio of the layer is added in an amount less than 30% by weight. In other words, a "doped" layer is a layer that is used to distinguish a host material from a dopant material of a certain layer, in consideration of the weight ratio. Also, the term "undoped" refers to any case other than the "doped" case. For example, when a layer contains a single material or a mixture of materials having the same properties as each other, the layer is included in the "undoped" layer. For example, if at least one of the materials constituting a certain layer is p-type and not all materials constituting the layer are n-type, the layer is included in the "undoped" layer. For example, if at least one of materials constituting a layer is an organic material and not all materials constituting the layer are inorganic materials, the layer is included in the "undoped" layer. For example, if all materials constituting a certain layer are organic materials, at least one of the materials constituting the layer is n-type and the other is p-type, when the n-type material is present in an amount of less than 30 wt%, or when the p-type material is present in an amount of less than 30 wt%, the layer is included in the "doped" layer.

Hereinafter, a light emitting device of the present invention and a light emitting display device including the same will be described with reference to the drawings.

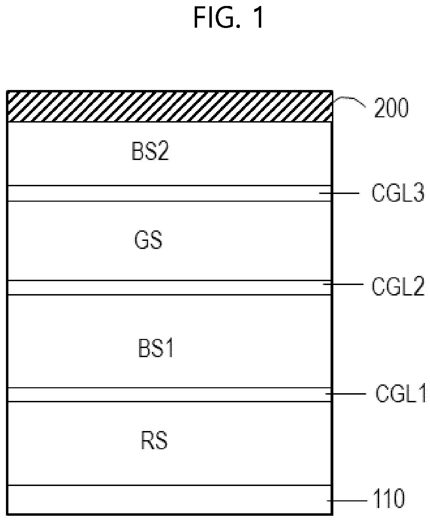

FIG. 1 is a cross-sectional view illustrating a light emitting device according to an embodiment of the present invention.

As shown in FIG. 1, the light emitting device according to the embodiment of the present invention includes a first electrode 110 and a second electrode 200 facing each other; a red stack RS, a first blue stack BS1, a green stack GS, and a second blue stack BS2 sequentially provided between the first electrode 110 and the second electrode 200; and charge generation layers CGL1, CGL2, and CGL3 provided between the respective stacks RS, BS1, GS, and BS2.

Here, the light emitting device according to FIG. 1 includes a single light emitting layer for each stack RS, BS1, GS, or BS2 in order to obtain high purity for each color to realize white color.

Here, each stack RS, BS1, GS, or BS2 includes a light emitting layer of each color, a hole transport layer disposed under the light emitting layer (close to the first electrode 110), and an electron transport layer disposed on the light emitting layer (close to the second electrode 200).

The first electrode 110 and the second electrode 200 are also referred to as an "anode" and a "cathode", respectively. In some cases, inverse to the configuration shown in FIG. 1, an anode may be provided on an upper side, and a cathode may be provided on a lower side.

At least one of the first electrode 110 and the second electrode 200 may include a transparent electrode, and the other may include a reflective electrode, thereby determining the passage direction of light.

In some cases, one of the first electrode 110 and the second electrode 200 is a transparent electrode and the other is a thin reflective electrode, so the strong cavity of the first and second electrodes 110 and 200 can be maintained, light can be emitted within a range having a small half width from each light emitting layer and thus light efficiency can be improved.

FIG. 1 shows that each of a red stack RS and a green stack GS is provided singly and that a blue stack has a double stack configuration including first and second blue stacks BS1 and BS2. This aims to compensate for the fact that the efficiency of the blue stack including the fluorescent light emitting layer is lower than that of the red stack RS and the green stack GS including phosphorescent light emitting layers. In some cases, the number of blue stacks may be decreased or increased by changing the material of the blue light emitting layer.

Meanwhile, the positions of the red stack RS, the first blue stack BS1, the green stack GS, and the second blue stack BS2 shown in FIG. 1 may be changed as needed.

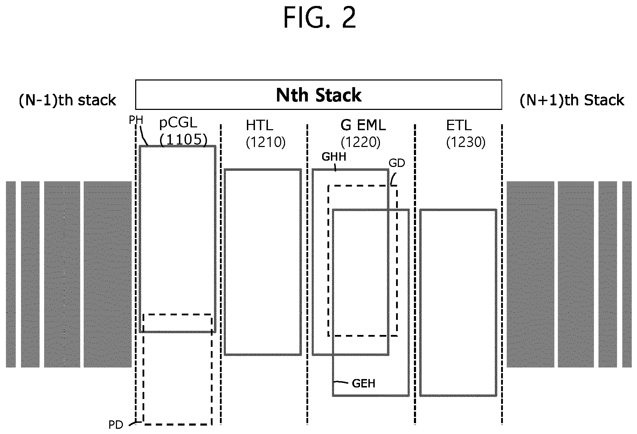

FIG. 2 is an energy band diagram for each layer of a green stack according to an embodiment of a light emitting device of the present invention.

In FIG. 2, N may be a natural number of 2 or more.

Accordingly, as the N^{th} stack, the green stack may be disposed as the second or next stack from the first electrode 110 and may be disposed between the first electrode 110 and a further next stack emitting light of a different color.

For example, FIG. 1 shows a configuration in which the green stack GS is provided between the first and second blue stacks BS1 and BS2, and satisfies the configuration of FIG. 2.

A light emitting unit including the green stack (N^{th} stack) provided in FIG. 2 may include a p-type charge generation layer (pCGL) 1105, a hole transport layer (HTL) 1210, a green light emitting layer (G EML) 1220, and an electron transport layer (ETL) 1230 which are stacked in that order.

That is, the light emitting unit including the green stack (N^{th} stack) of FIG. 2 includes the hole transport layer 1210 and the electron transport layer 1230, which are disposed on both sides of the green light emitting layer 1220, and is capable of confining holes and electrons in the green light emitting layer 1220 as a single phosphorescent light emitting layer without a separate control layer, thus emitting light with high external quantum efficiency in the green light emitting layer 1220. This is also possible by changing the material of the electron-transporting host (GEH) included in the green light emitting layer 1220 1210 and the electron transport layer 1230.

The material of the hole transport layer and the known material for the host of the phosphorescent layer generally used in the phosphorescent stack are determined in consideration of exciton distribution in each of phosphorescent layers present in the phosphorescent stack. When the materials are used in the green phosphorescent light emitting layer, the position of the light emitting region is biased toward the interface with the hole transport layer or the electron transport layer, so it is difficult to obtain a high light-emission efficiency from a phosphorescent green light emitting layer.

In the light emitting unit shown in FIG. 2, the p-type charge generation layer 1105 is a layer that generates holes and supplies the holes to the green light emitting layer 1220 because the green stack is not directly adjacent to the first electrode (or anode). The p-type charge generation layer 1105 includes an amine-based compound as a host (PH) and an organic material including a fluorene-based compound in an amount of 0.1 wt% to 30 wt% as a p-type dopant (PD) to promote hole generation and hole transport.

The LUMO energy level of the p-type dopant PD is approximately similar to the HOMO energy level of the host PH in the p-type charge generation layer 1105.

In addition, the material of the hole transport layer (HTL) 1210 has a HOMO energy level of about -5.8 eV to about -5.4 eV, and a HOMO energy level lower than the HOMO energy level of the host PH of the p-type charge generation layer (pCGL) 1105 to receive holes from the adjacent p-type charge generation layer (pCGL) 1105.

In addition, the green light emitting layer 1220 of the green stack in the light emitting device of the present invention includes an electron-transporting host (GEH), a hole-transporting host (GHH) and a green dopant (GD) doped in an amount of 1 wt% to 30 wt% in the hosts (GEH, GHH) .

The hole-transporting host (GHH) has a HOMO energy level of about -6.1 eV to about -5.4 eV, and has a HOMO energy level equal to or lower than the HOMO energy level of the hole transport layer (HTL) 1210 to receive holes from the adjacent hole transport layer (HTL) 1210.

In addition, the electron-transporting host GEH functions to receive electrons and effectively transfer the electrons to the green dopant GD and the overall energy band gap of the electron-transporting host GEH is lower than that of the hole-transporting host GHH. Accordingly, the HOMO energy level of the electron-transporting host GEH is about -6.8 eV to about -5.6 eV.

In addition, the green dopant GD preferably has a HOMO energy level higher than the HOMO energy level of the hole-transporting host GHH to receive holes from the hole-transporting host GHH. The green dopant GD may have an emission peak at a wavelength of 510 nm to 550 nm, and may include a metal complex compound such as an iridium complex compound.

In the light emitting device of the present invention, the green light emitting layer 1220 has the maximum luminous efficiency based on a single element structure not in contact with light emitting layers of other colors. For this purpose, one side of the green light emitting layer 1220 contacts the hole transport layer 1210 and the other side thereof contacts the electron transport layer 1230.

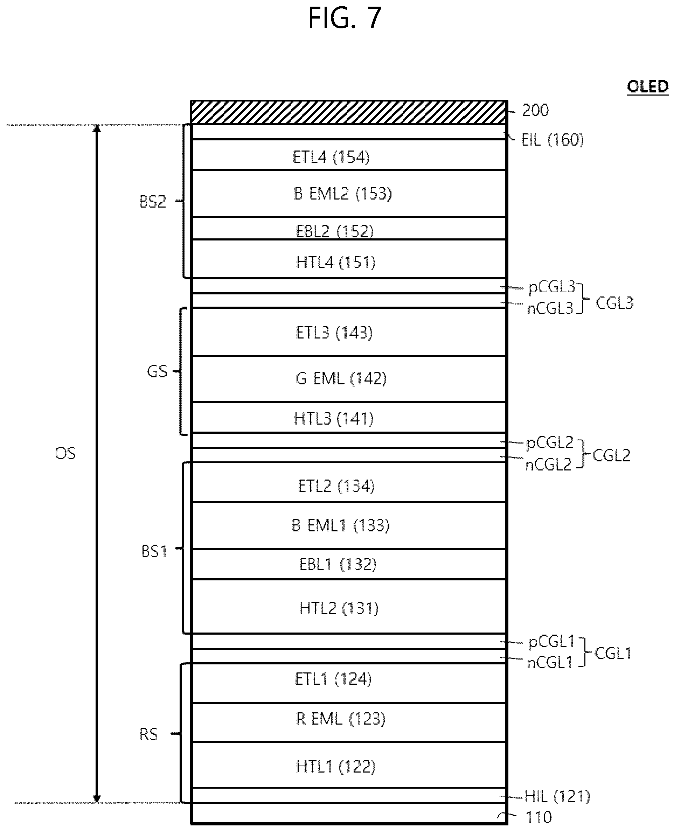

In addition, the other side of the electron transport layer 1230 that does not contact the green light emitting layer 1220 may contact the charge generation layer (nCGL) or the electron injection layer (see EIL of FIG. 7) of the charge generation layer (see CGL of FIG. 1) disposed between the electron transport layer 1230 and the next stack ((N+1)^{th} stack). The n-type charge generation layer (nCGL) may be an organic layer doped with a metal and the electron injection layer may be an inorganic material or an organic-inorganic compound having a metal compound such as LiF or Liq (lithium quinolate).

In addition, the other side of the electron transport layer 1230, which is not in contact with the green light emitting layer, may be in contact with an organic layer doped with a metal or an inorganic layer having a metal compound.

At least one of the p-type charge generation layer and the n-type charge generation layer is adjacent to a blue stack (BS1 or BS2 in FIG. 1) including a blue light emitting layer, and the blue light emitting layer may include a blue dopant having an emission peak of at a wavelength 420 nm to 480 nm.

The electron-transporting host (GEH) of the green light emitting layer 1220 in the light emitting device of the present invention may include a triazine compound represented by the following Formula 1.

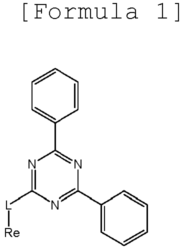

Re is at least one selected from the group consisting of a dibenzofuran group, a dibenzothiophene group, a triphenyl group, a triphenylene group, a carbazole group, a benzocarbazole group, a biscarbazole group, a fluorene group (e.g. 9,9-dimethylfluorene), an indenocarbazole (e.g. 7,7-Dimethyl-5,7-dihydroindeno[2,1-b]carbazole) and a phenyl-carbazole. L is a single bond or at least one selected from the group consisting of a phenyl group, a phenylene group, a biphenyl group, a biphenylene group, a dibenzofuran group, a dibenzofurylene group, and dibenzothiophene group, and a dibenzothienylene group.

In one embodiment, L is a biphenyl group or a phenyl group and Re is an indenocarbazole (e.g. 7,7-Dimethyl-5,7-dihydroindeno[2,1-b]carbazole). In one embodiment, L is a single bond and Re are two phenyl-carbazoles.

In one embodiment, L is a dibenzofuran group or a dibenzothiophene group and Re is a phenyl-carbazole or a triphenylene group.

In addition, examples of the compounds of Formula 1 described above may include the compounds of TRZ-01 to TRZ-27.

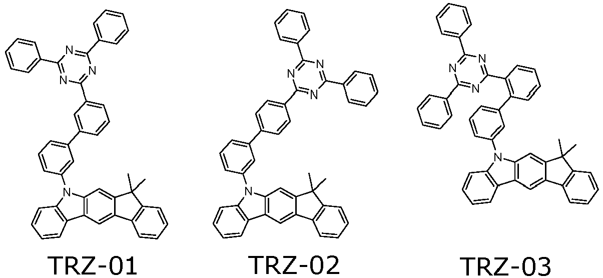

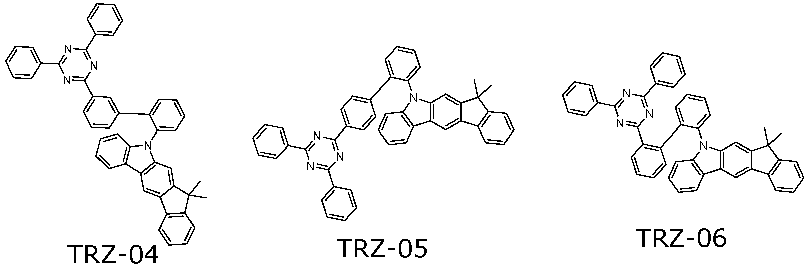

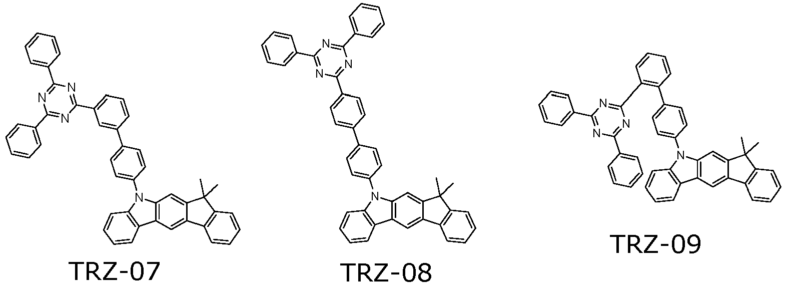

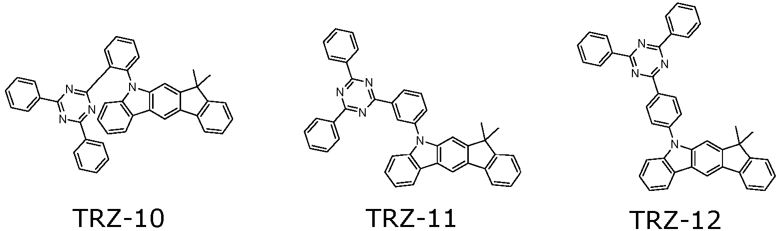

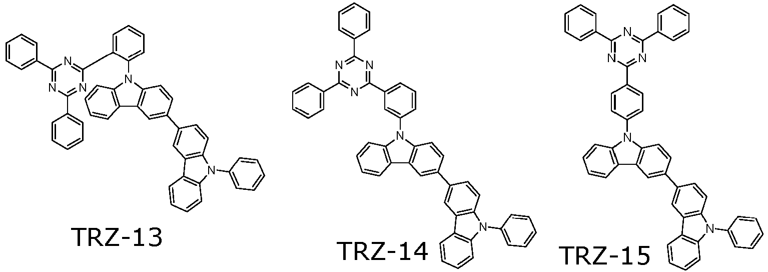

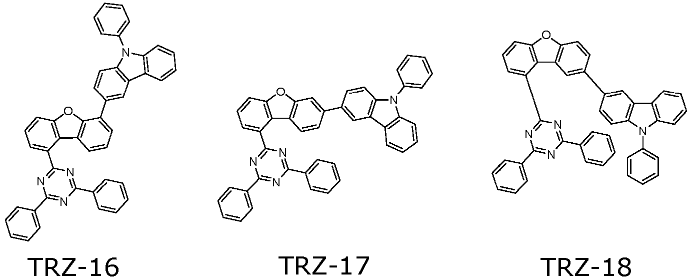

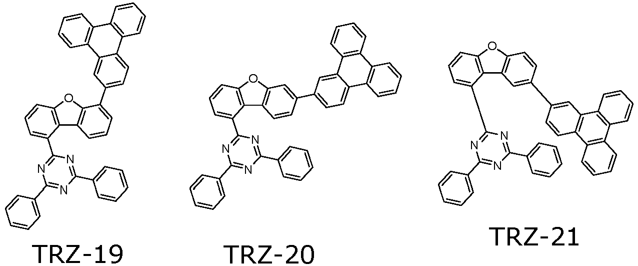

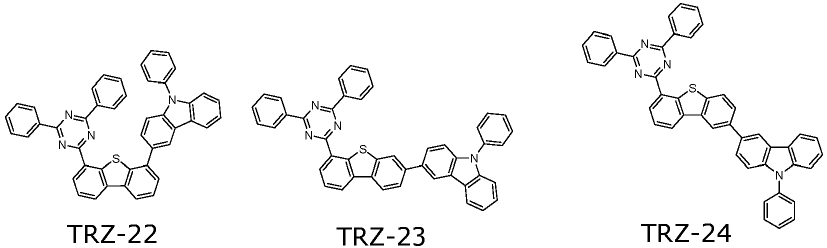

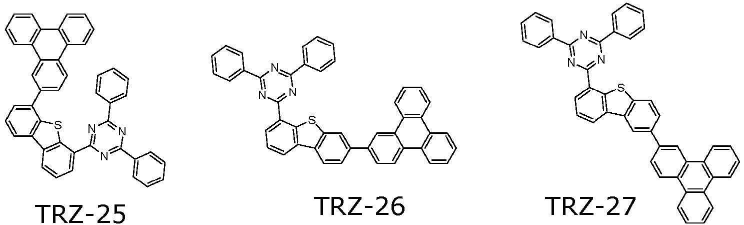

In addition, the hole transport layer 1210 in contact with the green light emitting layer (G EML) 1220 includes the following biscarbazole-based compound and thus is capable of effectively transporting holes while avoiding accumulation on the interface, without a separate control layer between the green light emitting layer 1220 and the hole transport layer 1210.

The biscarbazole-based compound contained in the hole transport layer 1210 includes a second material of Formula 2.

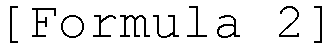

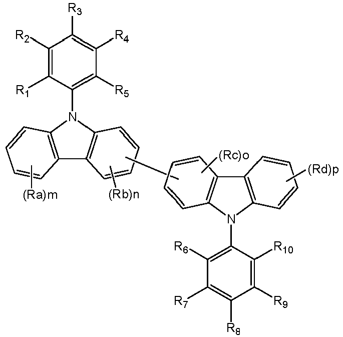

Ra to Rd are each independently selected from hydrogen, deuterium, halogen, a substituted or unsubstituted C1-C6 alkyl group, a substituted or unsubstituted C3-C6 cycloalkyl group, a substituted or unsubstituted C6-C15 aryl group, a substituted or unsubstituted C5-C9 heteroaryl group, a carbazole group, a dibenzofuran group, a dibenzothiophene group, a trialkylsilyl group, and a triarylsilyl group. m and p are each independently selected from integers from 0 to 4. n and o are each independently selected from integers from 0 to 3. R₁ to R₁₀ are each independently selected from hydrogen, deuterium, halogen, a substituted or unsubstituted C1-C6 alkyl group, a substituted or unsubstituted C6-C18 aryl group, a carbazole group, a phenyl-carbazole group, a dibenzofuran group, and a dibenzothiophene group; or two or more of R₁ to R₁₀ together with the phenyl group that they are connected with may form a condensed aryl group. Preferably, the C6-C18 aryl group may be a phenyl group, a biphenyl group, or a triphenylene group. Preferably, the condensed aryl groups may be a naphthyl group, a phenanthrene group, or a triphenylene group. Preferably, the C5-C9 heteroaryl group may contain one or more hetero atoms selected from oxygen, sulfur and nitrogen in its aryl ring structure.

In one embodiment, m, n, o, p are 0. In one embodiment, four of R₁ to R₅ are independently of each other hydrogen, deuterium or halogen and one of R₁ to R₅ is a phenyl group, a biphenyl group, a dibenzofuran group, a dibenzothiophene group, a carbazole group or a phenyl-carbazole group. In one embodiment, at least one of R₆ to R₁₀ are hydrogen, deuterium or halogen and at most four of R₆ to R₁₀ are independently of each other hydrogen, a phenyl group, a triphenylene group, a phenanthrene group, an anthracene group, a naphthyl group, or two or more of R₆ to R₁₀ together with the phenyl group that they are connected with may form a condensed aryl group, wherein the condensed aryl group is preferably a naphthyl group, a phenanthrene group, or a triphenylene group.

Moreover, examples of such a biscarbazole-based compound include the following materials BCA-01 to BCA-44.

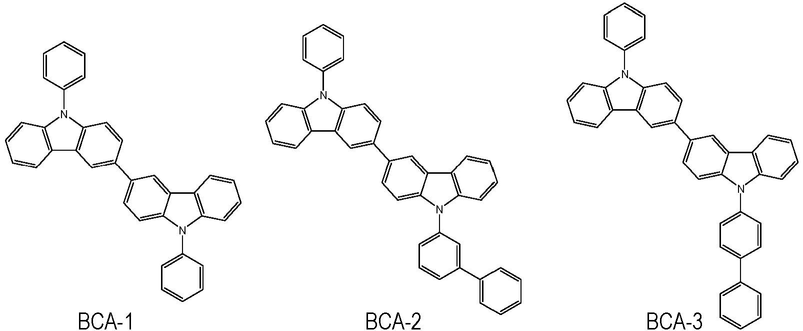

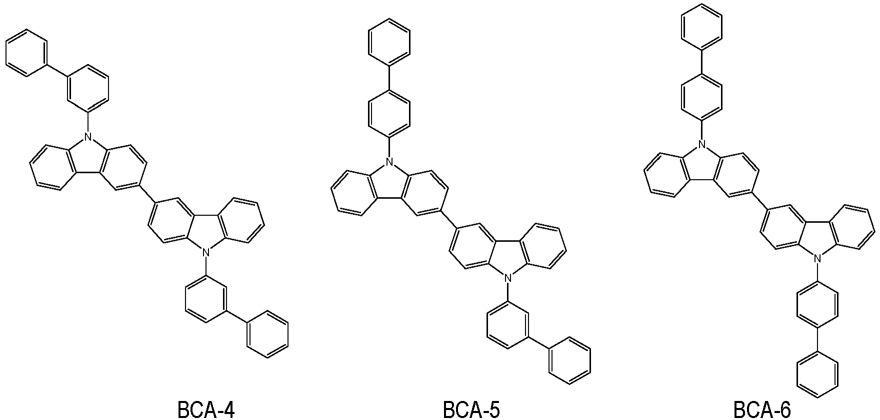

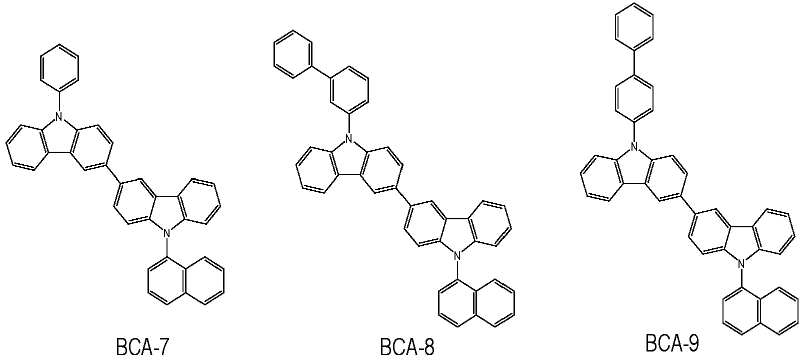

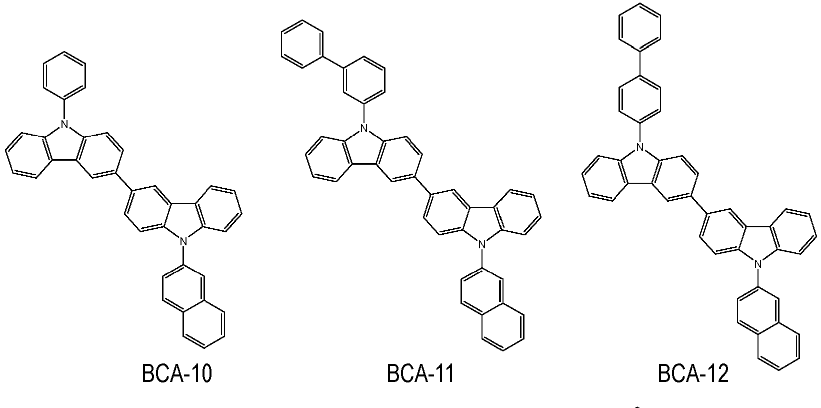

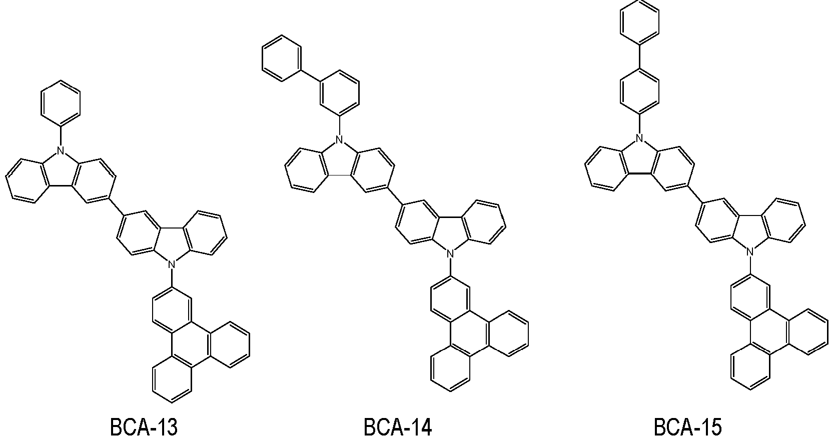

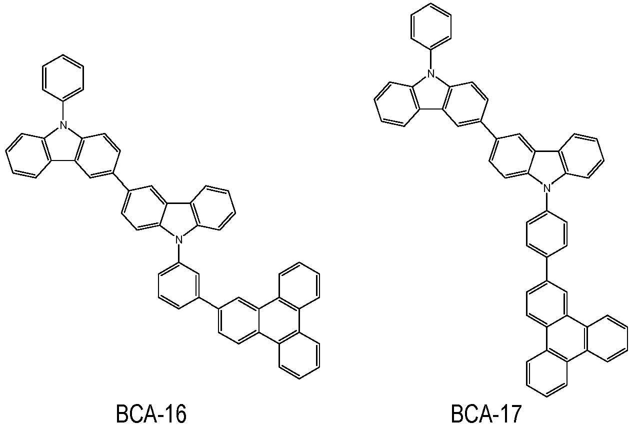

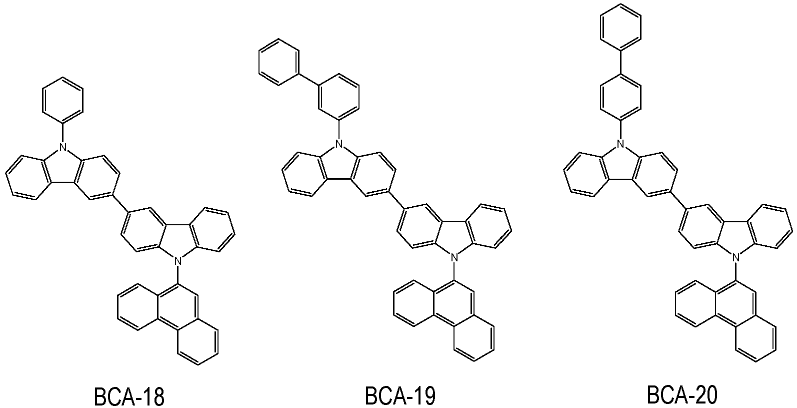

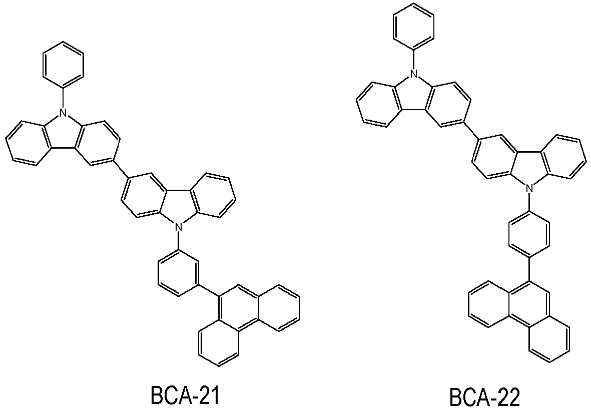

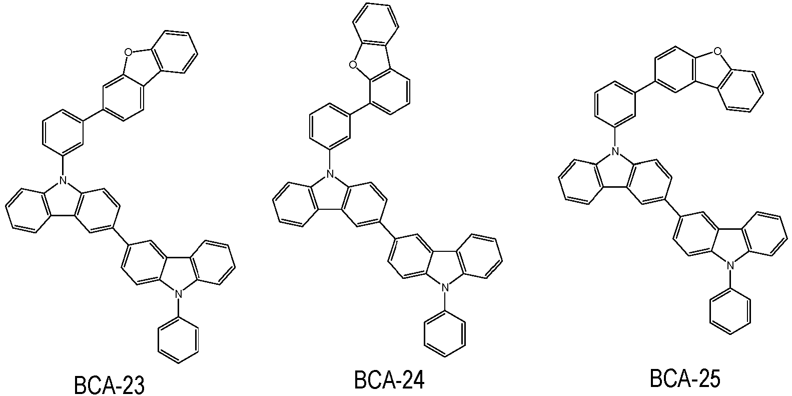

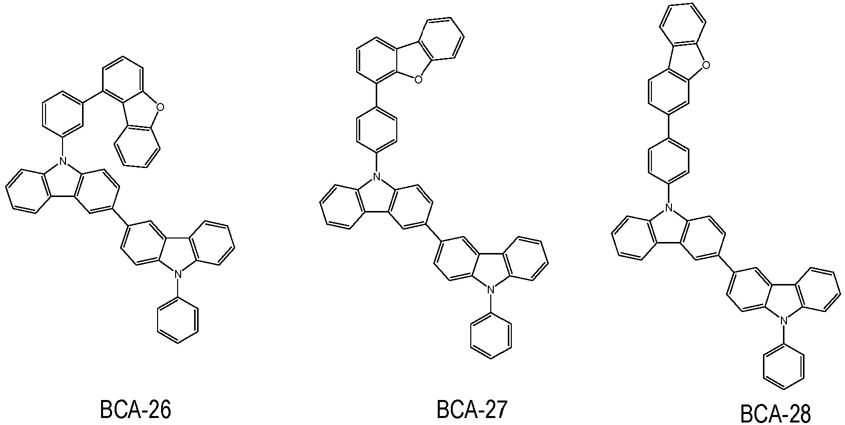

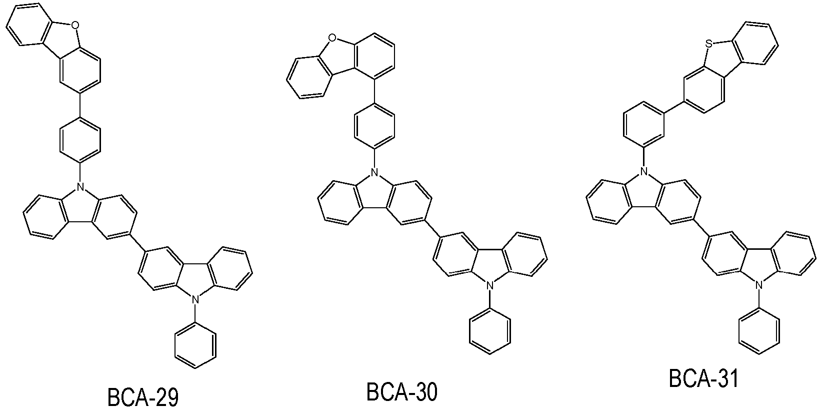

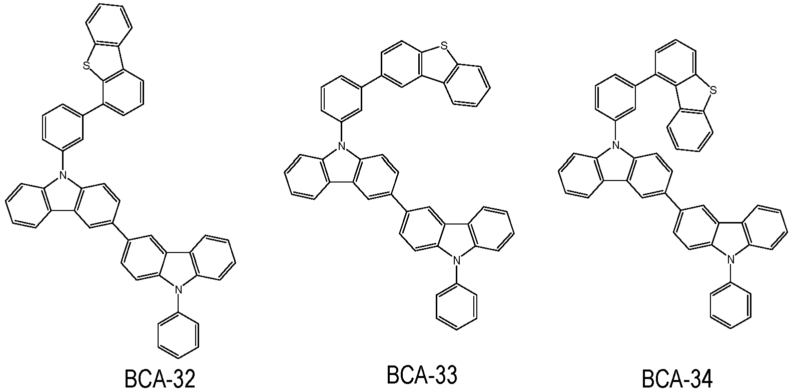

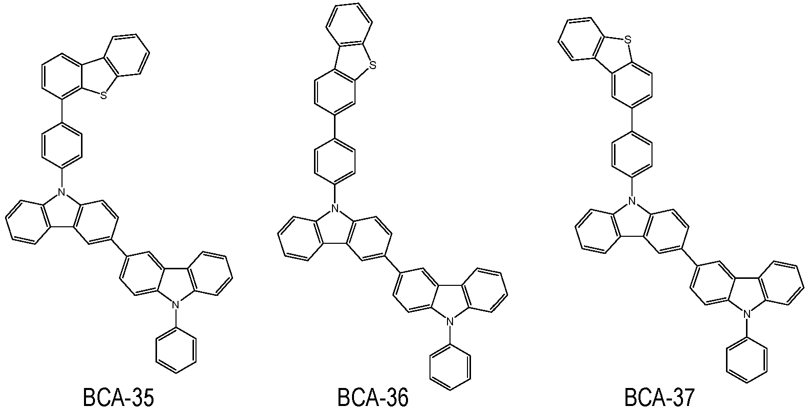

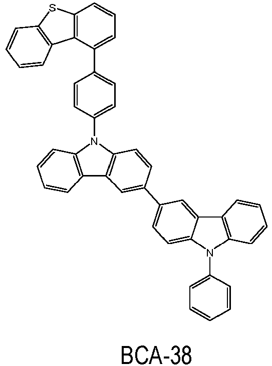

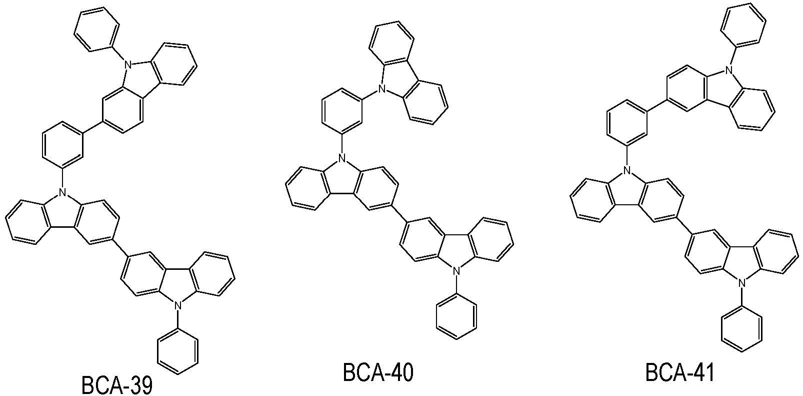

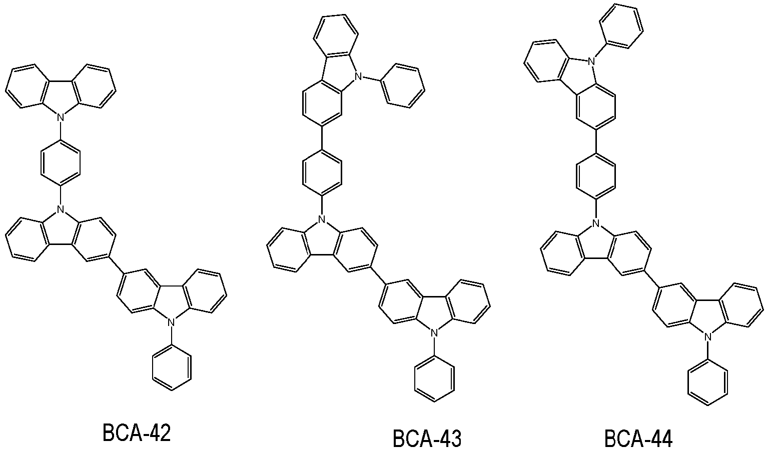

Hereinafter, the significance of each material will be determined by changing the materials of the hole-transporting host of the hole transport layer and the electron-transporting host of the adjacent phosphorescent green light emitting layer in the structure of a light emitting device having a phosphorescent green light emitting layer as a single stack.

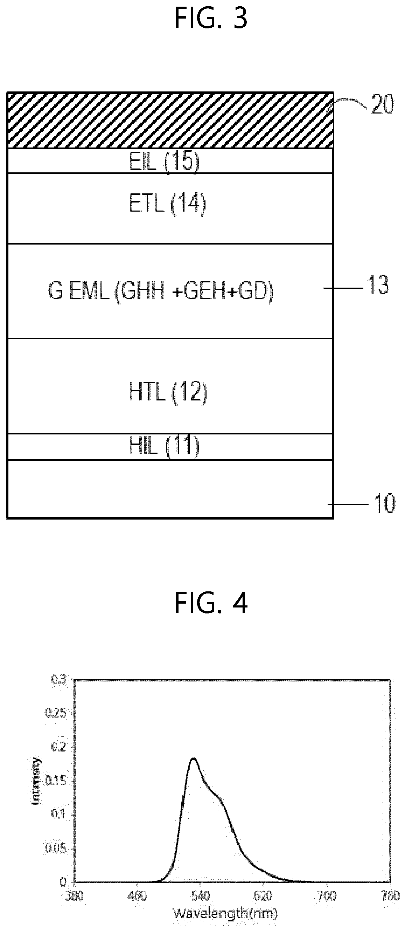

The light emitting devices of FIG. 3 according to the first experimental example group (Ex1-1 to Ex1-52) and the second experimental example group (Ex2-1 to Ex2-71) were formed and comparatively tested.

FIG. 3 is a cross-sectional view illustrating light emitting devices used in the first and second experimental example groups.

As shown in FIG. 3, the light emitting devices according to the first experimental example group (Ex1-1 to Ex1-52) are formed in accordance with the following process.

First, a first electrode 10 is formed using ITO.

Then, DNTPD and MgF₂ are co-deposited at a weight ratio of 1:1 to 7.5 nm to form a hole injection layer (HIL) 11.

Then, an amine-based compound (HM-01 to HM-25) is deposited to a thickness of 15 nm to form a hole transport layer (HTL) 12.

Then, a green light emitting layer (G EML) 13 is formed to a thickness of 40 nm by doping a mixture of CBP as a hole-transporting host and a triazine-based compound as an electron-transporting host GEH at a weight ratio of 1:1 at 15 wt% with Ir(ppy)₃.

Then, TPBI is deposited to a thickness of 25 nm to form an electron transport layer (ETL) 14.

Then, LiF is deposited to a thickness of 2 nm to form an electron injection layer (EIL) 15 and then a second electrode 20 is formed using aluminum (Al).

In the experiments of the first experimental example group (Ex1-1 to Ex1-52), the material of the hole transport layer 12 is an amine-based compound and the electron-transporting host of the green phosphorescent layer is a triazine-based compound represented by Formula 1. These experiments are Reference Experiments.

The amine-based compound used in the first experimental example group (Ex1-1 to Ex1-52) may be selected from the following compounds of HM-01 to HM-25.

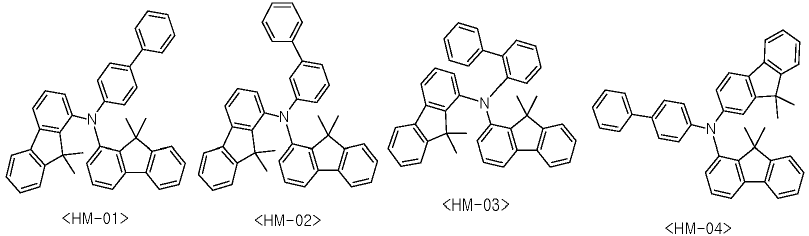

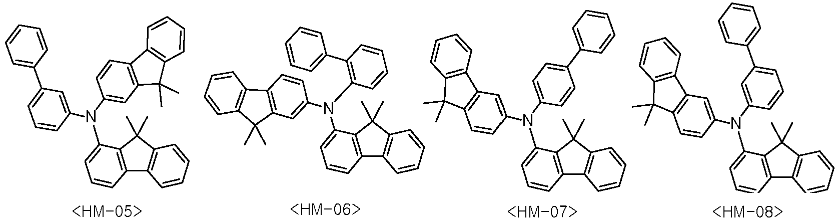

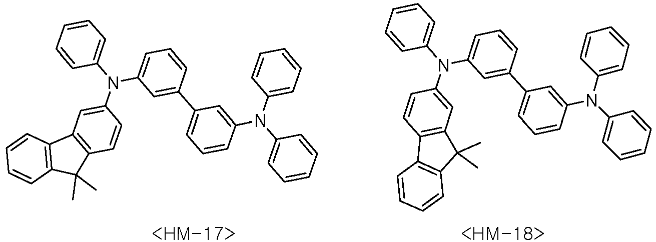

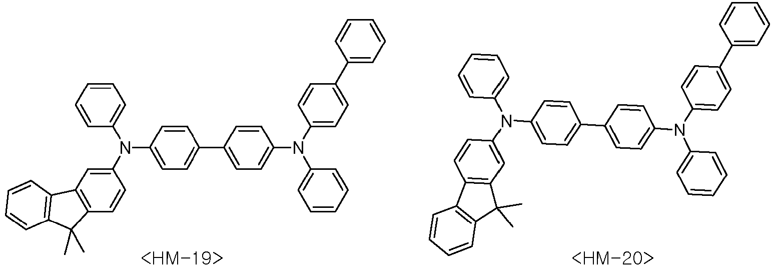

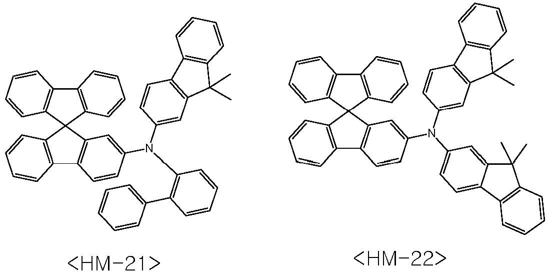

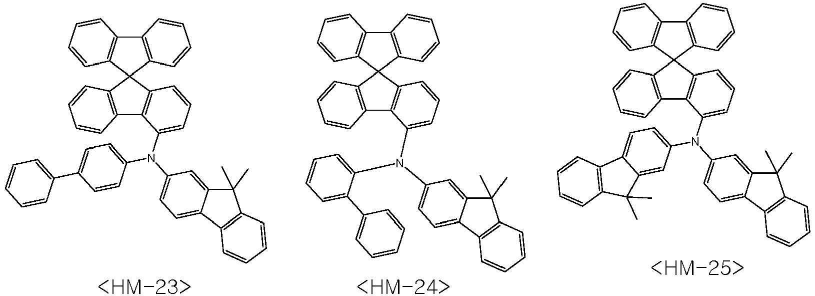

The driving voltages, efficiencies, and external quantum efficiencies of the first experimental example group (Ex1-1 to Ex1-52) are shown in Table 1 below.

**[Table 1] - Reference Examples not according to the invention**

| Item | Structure | | **Voltage (V)@10mA/cm²** | **Efficiency (cd/A)** | **EQE (%)** |
|---|---|---|---|---|---|
| | HTL | GEH | | | |
| Ex1-1 | HM-01 | TRZ-20 | 3.42 | 59.8 | 16.4 |
| Ex1-2 | HM-02 | TRZ-20 | 3.50 | 58.5 | 16.0 |
| Ex1-3 | HM-03 | TRZ-20 | 3.56 | 59.2 | 16.2 |
| Ex1-4 | HM-04 | TRZ-20 | 3.43 | 70.1 | 19.2 |
| Ex1-5 | HM-05 | TRZ-20 | 3.59 | 58.7 | 16.1 |
| Ex1-6 | HM-06 | TRZ-20 | 3.59 | 58.6 | 16.1 |
| Ex1-7 | HM-07 | TRZ-20 | 3.42 | 60.7 | 16.6 |
| Ex1-8 | HM-08 | TRZ-20 | 3.58 | 59.7 | 16.4 |
| Ex1-9 | HM-09 | TRZ-20 | 3.59 | 68.5 | 18.8 |
| Ex1-10 | HM-10 | TRZ-20 | 3.51 | 68.1 | 18.6 |
| Ex1-11 | HM-11 | TRZ-20 | 3.53 | 70.4 | 19.3 |
| Ex1-12 | HM-12 | TRZ-20 | 3.44 | 57.8 | 15.8 |
| Ex1-13 | HM-13 | TRZ-20 | 3.40 | 71.2 | 19.5 |
| Ex1-14 | HM-14 | TRZ-20 | 3.44 | 66.7 | 18.3 |
| Ex1-15 | HM-15 | TRZ-20 | 3.51 | 57.7 | 15.8 |
| Ex1-16 | HM-16 | TRZ-20 | 3.51 | 70.4 | 19.3 |
| Ex1-17 | HM-17 | TRZ-20 | 3.57 | 64.1 | 17.6 |
| Ex1-18 | HM-18 | TRZ-20 | 3.57 | 65.8 | 18.0 |
| Ex1-19 | HM-19 | TRZ-20 | 3.50 | 70.7 | 19.4 |
| Ex1-20 | HM-20 | TRZ-20 | 3.48 | 63.2 | 17.3 |
| Ex1-21 | HM-21 | TRZ-20 | 3.55 | 69.8 | 19.1 |
| Ex1-22 | HM-22 | TRZ-20 | 3.56 | 63.2 | 17.3 |
| Ex1-23 | HM-23 | TRZ-20 | 3.41 | 63.0 | 17.3 |
| Ex1-24 | HM-24 | TRZ-20 | 3.53 | 66.3 | 18.2 |
| Ex1-25 | HM-25 | TRZ-20 | 3.41 | 63.1 | 17.3 |
| Ex1-26 | HM-01 | TRZ-01 | 3.48 | 68.7 | 18.8 |
| Ex1-27 | HM-01 | TRZ-02 | 3.56 | 70.8 | 19.4 |
| Ex1-28 | HM-01 | TRZ-03 | 3.56 | 59.0 | 16.2 |
| Ex1-29 | HM-01 | TRZ-04 | 3.41 | 62.4 | 17.1 |
| Ex1-30 | HM-01 | TRZ-05 | 3.45 | 70.7 | 19.4 |
| Ex1-31 | HM-18 | TRZ-06 | 3.46 | 60.2 | 16.5 |
| Ex1-32 | HM-18 | TRZ-07 | 3.53 | 62.2 | 17.1 |
| Ex1-33 | HM-18 | TRZ-08 | 3.57 | 57.3 | 15.7 |
| Ex1-34 | HM-18 | TRZ-09 | 3.53 | 58.2 | 15.9 |
| Ex1-35 | HM-18 | TRZ-10 | 3.41 | 63.1 | 17.3 |
| Ex1-36 | HM-18 | TRZ-11 | 3.57 | 59.1 | 16.2 |
| Ex1-37 | HM-22 | TRZ-12 | 3.50 | 59.3 | 16.2 |
| Ex1-38 | HM-22 | TRZ-13 | 3.50 | 64.7 | 17.7 |
| Ex1-39 | HM-22 | TRZ-14 | 3.51 | 65.4 | 17.9 |
| Ex1-40 | HM-22 | TRZ-15 | 3.55 | 67.1 | 18.4 |
| Ex1-41 | HM-22 | TRZ-16 | 3.44 | 59.6 | 16.3 |
| Ex1-42 | HM-22 | TRZ-17 | 3.59 | 63.7 | 17.4 |
| Ex1-43 | HM-22 | TRZ-18 | 3.53 | 62.1 | 17.0 |
| Ex1-44 | HM-22 | TRZ-19 | 3.52 | 59.8 | 16.4 |
| Ex1-45 | HM-22 | TRZ-20 | 3.48 | 64.5 | 17.7 |
| Ex1-46 | HM-22 | TRZ-21 | 3.44 | 58.7 | 16.1 |
| Ex1-47 | HM-22 | TRZ-22 | 3.43 | 59.7 | 16.4 |
| Ex1-48 | HM-22 | TRZ-23 | 3.55 | 58.1 | 15.9 |
| Ex1-49 | HM-22 | TRZ-24 | 3.45 | 68.2 | 18.7 |
| Ex1-50 | HM-22 | TRZ-25 | 3.41 | 67.1 | 18.4 |
| Ex1-51 | HM-22 | TRZ-26 | 3.50 | 59.8 | 16.4 |
| Ex1-52 | HM-22 | TRZ-27 | 3.54 | 69.2 | 18.9 |

That is, when an amine-based compound is used as the hole transport layer 12 of FIG. 3 in the first experimental example group (Ex1-1 to Ex1-52), the external quantum efficiency varies from 16% to 19.5%. It can be seen that this characteristic occurs regardless of the material of the electron-transporting host of the green light emitting layer. The second experimental example group (Ex2-1 to Ex2-71) uses the device structure of FIG. 3, but the material of the hole transport layer 12 is changed to a biscarbazole-based compound and the material for the electron-transporting host of the green light emitting layer 13 is a triazine-based compound. The results are shown in Table 2.

**[Table 2] - Examples according to the invention**

| Item | Structure | | **Voltage (V)@10mA/cm ²** | **Efficiency (cd/A)** | **EQE (%)** |
|---|---|---|---|---|---|
| | HTL | GEH | | | |
| Ex2-1 | BCA-01 | TRZ-20 | 3.57 | 82.3 | 22.5 |
| Ex2-2 | BCA-02 | TRZ-20 | 3.58 | 87.5 | 24.0 |
| Ex2-3 | BCA-03 | TRZ-20 | 3.44 | 87.0 | 23.8 |
| Ex2-4 | BCA-04 | TRZ-20 | 3.40 | 86.6 | 23.7 |
| Ex2-5 | BCA-05 | TRZ-20 | 3.59 | 87.7 | 24.0 |
| Ex2-6 | BCA-06 | TRZ-20 | 3.48 | 85.6 | 23.5 |
| Ex2-7 | BCA-07 | TRZ-20 | 3.44 | 87.0 | 23.8 |
| Ex2-8 | BCA-08 | TRZ-20 | 3.43 | 83.5 | 22.9 |
| Ex2-9 | BCA-09 | TRZ-20 | 3.55 | 90.5 | 24.8 |
| Ex2-10 | BCA-10 | TRZ-20 | 3.45 | 86.8 | 23.8 |
| Ex2-11 | BCA-11 | TRZ-20 | 3.57 | 82.5 | 22.6 |
| Ex2-12 | BCA-12 | TRZ-20 | 3.46 | 87.5 | 24.0 |
| Ex2-13 | BCA-13 | TRZ-20 | 3.51 | 89.6 | 24.5 |
| Ex2-14 | BCA-14 | TRZ-20 | 3.59 | 82.2 | 22.5 |
| Ex2-15 | BCA-15 | TRZ-20 | 3.55 | 83.2 | 22.8 |
| Ex2-16 | BCA-16 | TRZ-20 | 3.49 | 90.3 | 24.7 |
| Ex2-17 | BCA-17 | TRZ-20 | 3.54 | 88.7 | 24.3 |
| Ex2-18 | BCA-18 | TRZ-20 | 3.60 | 82.3 | 22.5 |
| Ex2-19 | BCA-19 | TRZ-20 | 3.42 | 89.6 | 24.6 |
| Ex2-20 | BCA-20 | TRZ-20 | 3.44 | 84.6 | 23.2 |
| Ex2-21 | BCA-21 | TRZ-20 | 3.48 | 85.6 | 23.4 |
| Ex2-22 | BCA-22 | TRZ-20 | 3. 60 | 89.5 | 24.5 |
| Ex2-23 | BCA-23 | TRZ-20 | 3.44 | 86.4 | 23.7 |
| Ex2-24 | BCA-24 | TRZ-20 | 3.41 | 83.1 | 22.8 |
| Ex2-25 | BCA-25 | TRZ-20 | 3.51 | 86.6 | 23.7 |
| Ex2-26 | BCA-26 | TRZ-20 | 3.56 | 90.1 | 24.7 |
| Ex2-27 | BCA-27 | TRZ-20 | 3.52 | 87.4 | 23.9 |
| Ex2-28 | BCA-28 | TRZ-20 | 3.47 | 86.6 | 23.7 |
| Ex2-29 | BCA-29 | TRZ-20 | 3.58 | 87.8 | 24.1 |
| Ex2-30 | BCA-30 | TRZ-20 | 3.55 | 82.6 | 22.6 |
| Ex2-31 | BCA-31 | TRZ-20 | 3.58 | 82.8 | 22.7 |
| Ex2-32 | BCA-32 | TRZ-20 | 3.49 | 82.6 | 22.6 |
| Ex2-33 | BCA-33 | TRZ-20 | 3.46 | 88.4 | 24.2 |
| Ex2-34 | BCA-34 | TRZ-20 | 3.58 | 86.1 | 23.6 |
| Ex2-35 | BCA-35 | TRZ-20 | 3.46 | 84.1 | 23.0 |
| Ex2-36 | BCA-36 | TRZ-20 | 3.50 | 89.9 | 24.6 |
| Ex2-37 | BCA-37 | TRZ-20 | 3.58 | 85.7 | 23.5 |
| Ex2-38 | BCA-38 | TRZ-20 | 3.55 | 84.9 | 23.3 |
| Ex2-39 | BCA-39 | TRZ-20 | 3.52 | 89.2 | 24.4 |
| Ex2-40 | BCA-40 | TRZ-20 | 3.51 | 82.3 | 22.6 |
| Ex2-41 | BCA-41 | TRZ-20 | 3.44 | 87.3 | 23.9 |
| Ex2-42 | BCA-42 | TRZ-20 | 3.49 | 83.0 | 22.7 |
| Ex2-43 | BCA-43 | TRZ-20 | 3.58 | 82.1 | 22.5 |
| Ex2-44 | BCA-44 | TRZ-20 | 3.46 | 90.3 | 24.7 |
| Ex2-45 | BCA-02 | TRZ-01 | 3.42 | 84.2 | 23.1 |
| Ex2-46 | BCA-02 | TRZ-02 | 3.59 | 88.4 | 24.2 |
| Ex2-47 | BCA-02 | TRZ-03 | 3.58 | 84.1 | 23.0 |
| Ex2-48 | BCA-02 | TRZ-04 | 3.58 | 87.2 | 23.9 |
| Ex2-49 | BCA-02 | TRZ-05 | 3.46 | 87.4 | 23.9 |
| Ex2-50 | BCA-02 | TRZ-06 | 3.57 | 82.7 | 22.6 |
| Ex2-51 | BCA-02 | TRZ-07 | 3.59 | 84.0 | 23.0 |
| Ex2-52 | BCA-02 | TRZ-08 | 3.50 | 84.3 | 23.1 |
| Ex2-53 | BCA-02 | TRZ-09 | 3.47 | 85.2 | 23.3 |
| Ex2-54 | BCA-02 | TRZ-10 | 3.58 | 82.5 | 22.6 |
| Ex2-55 | BCA-02 | TRZ-11 | 3.42 | 88.7 | 24.3 |
| Ex2-56 | BCA-02 | TRZ-12 | 3.56 | 88.6 | 24.3 |
| Ex2-57 | BCA-02 | TRZ-13 | 3.53 | 88.0 | 24.1 |
| Ex2-58 | BCA-02 | TRZ-14 | 3.47 | 83.3 | 22.8 |
| Ex2-59 | BCA-02 | TRZ-15 | 3.57 | 85.3 | 23.4 |
| Ex2-60 | BCA-02 | TRZ-16 | 3.56 | 88.9 | 24.4 |
| Ex2-61 | BCA-02 | TRZ-17 | 3.41 | 89.4 | 24.5 |
| Ex2-62 | BCA-02 | TRZ-18 | 3.45 | 90.3 | 24.7 |
| Ex2-63 | BCA-02 | TRZ-19 | 3.45 | 81.6 | 22.4 |
| Ex2-64 | BCA-02 | TRZ-20 | 3.56 | 90.3 | 24.7 |
| Ex2-65 | BCA-02 | TRZ-21 | 3.40 | 85.7 | 23.5 |
| Ex2-66 | BCA-02 | TRZ-22 | 3.41 | 88.8 | 24.3 |
| Ex2-67 | BCA-02 | TRZ-23 | 3.50 | 89.0 | 24.4 |
| Ex2-68 | BCA-02 | TRZ-24 | 3.45 | 88.6 | 24.3 |
| Ex2-69 | BCA-02 | TRZ-25 | 3.52 | 89.2 | 24.4 |
| Ex2-70 | BCA-02 | TRZ-26 | 3.44 | 83.2 | 22.8 |
| Ex2-71 | BCA-02 | TRZ-27 | 3.59 | 87.9 | 24.1 |

As can be seen from Table 2, the second experimental example group (Ex2-1 to Ex2-71) had an increased external quantum efficiency (EQE) of 22% or more, unlike the first experimental example group (Ex1-1 to Ex1-52). In addition, it can be seen that the efficiency of the hole transport layer is greatly improved compared to the first experimental example group (Ex1-1 to Ex1-52), in which the hole transport layer includes an amine-based compound.

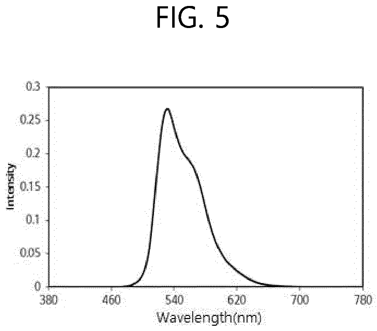

FIG. 4 is a graph showing the emission spectrum of the first experimental example group, and FIG. 5 is a graph showing the emission spectrum of the second experimental example group.

It can be seen that the intensity of emission of green light in the emission spectrum of the second experimental example group of FIG. 5 compared to FIG. 4 is increased by 25% to 30% or more, and when a triazine-based compound is used for the electron-transporting host of the single phosphorescent green light emitting layer and a biscarbazole-based compound is used for the hole-transporting host of the hole transport layer, green luminous efficiency is greatly improved.

Hereinafter, the relationship between driving voltage, efficiency, and lifespan in the structure of the third experimental example (Ex3), in which the external quantum efficiency is improved through the change in configuration, and in the structure of the fourth experimental example (Ex4), including the hole transport layer and the green light emitting layer according to the present invention, will be described. The third experimental example (Ex3) and the fourth experimental example (Ex4) includes a green light emitting device having a green light emitting layer as an emitting layer.

**[Table 3]**

| Green light emitting device | Driving voltage @100mA/cm² | Efficiency(EQE) | Lifespan |
|---|---|---|---|
| **Ex3** | 7.6V | 23.5% | 100% |
| **Ex4** | 4.5V | 16.8% | 111% |

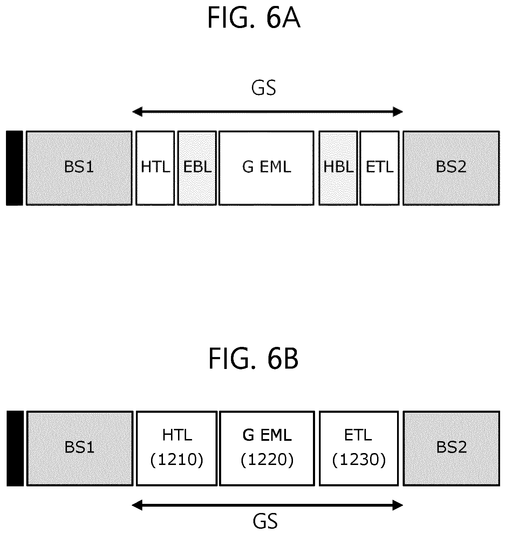

FIGS. 6A and 6B illustrate the configuration of a green phosphorescent stack GS of third and fourth experimental examples.

As shown in FIG. 6A, the green phosphorescent stack GS of the third experimental example includes an electron-blocking layer EBL between a green light emitting layer G EML and a hole transport layer HTL to prevent electrons from passing from the green light emitting layer G EML to the hole transport layer, and a hole-blocking layer HBL between the green light emitting layer G EML and the electron transport layer ETL to prevent holes from passing from the green light emitting layer G EML to the electron transport layer ETL.

Here, the hole transport layer HTL of the third experimental example Ex3 includes an amine-based compound, and the electron-transporting host in the green light emitting layer (G EML) includes a known electron-transporting host along with a phosphorescent dopant such as TPBi.

When the current density is 100 mA/cm² and the external quantum efficiency (EQE) is 23.5% in the third experimental example (Ex3), the driving voltage is 7.6V, as shown in Table 3.

As shown in FIG. 6B, in the green phosphorescent stack (GS) of the fourth experimental example (Ex4), unlike the above-described third experimental example (Ex3), the green (phosphorescent) light emitting layer (G EML) 1220 contacts the hole transport layer (HTL) 1210 and the electron transport layer (ETL) 1230, and does not include a control layer relating to hole and electron transport in addition to a separate transport layer. However, the hole transport layer (HTL) 1210 of the fourth experimental example (Ex4) includes an amine-based compound, the electron-transporting host of the green light emitting layer includes a triazine-based compound, and the materials for the first experimental group of Table 1 are used.

In this case, in the fourth experimental example (Ex4), by reducing the use of layers in the green phosphorescent stack (GS), the driving voltage is decreased to 4.5V, as shown in Table 3, which corresponds to a decrease of 41% in the driving voltage of the fourth experimental example (Ex4) compared to the third experimental example. This reduction in the driving voltage is caused by a reduction in the number of interfaces in the green phosphorescent stack GS.

In addition, the lifespan is improved to 111%, which corresponds to an 11% increase compared to the third experimental example.

Meanwhile, as shown in Table 2, when the material for the hole transport layer that is in contact with the green light emitting layer 1220 is a biscarbazole-based compound, unlike the first experimental example, electrons and holes are confined and are thus likely to be combined together inside the green light emitting layer 1220. It can be seen from this that the effects of reducing the driving voltage, prolonging the lifespan, and increasing efficiency can be obtained using a biscarbazole-based compound as the material of a hole transport layer and using a triazine-based compound as the material for an electron-transporting host of a green light emitting layer contacting the same in a green phosphorescent stack including at least one green light emitting layer.

Hereinafter, an example in which a light emitting device has a four-stack structure of FIG. 1 including the above-described green phosphorescent stack will be described

FIG. 7 is a cross-sectional view illustrating light emitting devices according to fifth to seventh experimental examples of the present invention.

As shown in FIG. 7, an internal stack OS between a first electrode 110 and a second electrode 200 in the light emitting device OLED of the present invention has a red stack RS, a first charge generation layer CGL1, a first blue stack BS1, a second charge generation layer CGL2, a green stack GS, a third charge generation layer CGL3, and a second blue stack BS2, which are stacked on a first electrode 110 in that order.

Here, the red stack RS and the green stack GS are phosphorescent stacks and the first and second blue stacks BS1 and BS2 are fluorescent stacks.

The red stack RS includes a hole injection layer 121, a first hole transport layer (HTL1) 122, a red light emitting layer (R EML) 123, and a first electron transport layer (ETL1) 124, which are stacked in that order on the first electrode 110.

The first to third charge generation layers CGL1, CGL2, and CGL3 include n-type charge generation layers nCGL1, nCGL2, and nCGL3 and p-type charge generation layers pCGL1, pCGL2, and pCGL3, respectively.

The first blue stack BS1 is formed on the first charge generation layer CGL1, and includes a second hole transport layer (HTL2) 131, a first electron-blocking layer (EBL1) 132, a first blue light emitting layer (B EML1) 133, and a second electron transport layer (ETL2)134.

In addition, the green stack GS includes a third hole transport layer (HTL3) 141, a green light emitting layer (G EML) 142, and a third electron transport layer (ETL3) 143.

The second blue stack BS2 is formed on the third charge generation layer CGL3, and includes a fourth hole transport layer (HTL4) 151, a second electron-blocking layer (EBL2) 152, a second blue light emitting layer (B EML2) 153, and a fourth electron transport layer (ETL4) 154.

Here, the first and second blue stacks BS1 and BS2 include first and second electron-blocking layers 132 and 152, respectively, unlike the other color stacks, and the first and second electron-blocking layers 132 and 152 are formed using a material with a high mobility rate to increase efficiency comparable to adjacent phosphorescent stacks in order to prevent electrons from passing from the electron transport layers 134 and 154 to hole transport layers 131 and 151. In some cases, the material of the hole transport layers 131 and 151 may be changed or omitted.

The fifth to seventh experimental examples were conducted by changing only the material of the hole-transporting host in the third hole transport layer 141, and the green light emitting layer 142 of the green stack GS and the remaining layers were the same.

**[Table 4]**

| Item | | **Ex5** | **Ex6** | **Ex7** |
|---|---|---|---|---|
| Efficiency | R [Cd/A] | 14.3 | 13.6 | 14.2 |
| | G[Cd/A] | 39.5 | 28.8 | 40.3 |
| | B[Cd/A] | 5.2 | 4.8 | 5.3 |
| | EQE(%) | 45.6 | 40.2 | 46.0 |
| Driving voltage | V | 21.5 | 17.4 | 17.5 |
| Color coordinates | Rx | 0.692 | 0.693 | 0.692 |
| | Ry | 0.306 | 0.305 | 0.307 |
| | Gx | 0.276 | 0.272 | 0.276 |
| | Gy | 0.692 | 0.690 | 0.692 |
| | Bx | 0.148 | 0.147 | 0.148 |
| | By | 0.060 | 0.054 | 0.060 |
| | Wx | 0.341 | 0.332 | 0.339 |
| | Wy | 0.355 | 0.313 | 0.355 |

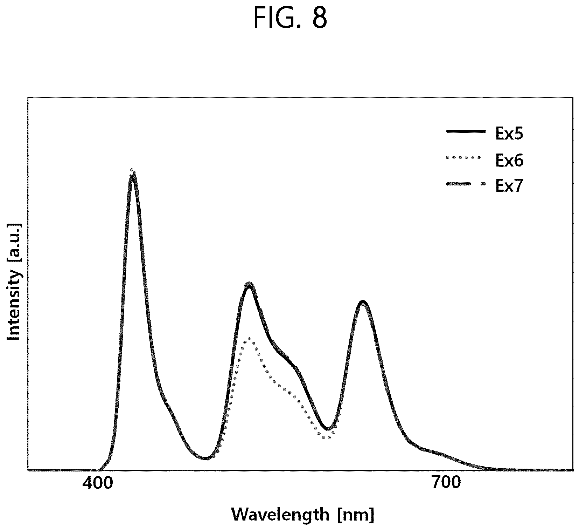

FIG. 8 is a graph showing white emission spectra of light emitting devices according to fifth to seventh experimental examples of FIG. 7.

In the fifth experimental example (Ex5) and the sixth experimental example (Ex6), like Ex1-15 of the first experimental example group, the third hole transport layer 141 includes HM-15 and an electron-transporting host (GEH) of the green light emitting layer 142 is TRZ-20. However, in the fifth experimental example (Ex5), the electron-blocking layer (EBL) and the hole-blocking layer (HBL) are additionally formed so as to contact the green light emitting layer 142 to improve efficiency.

In the seventh experimental example (Ex7), the third hole transport layer 141 includes BCA-03 and the electron-transporting host GEH of the green light emitting layer 142 is TRZ-20.

In the fifth experimental example (Ex5), as shown in FIG. 8, particularly, the effect of improving green efficiency is obtained, but as shown in Table 4, the driving voltage is increased by 4V or more compared to the sixth experimental example (Ex6). That is, it has a structure in which the driving voltage is increased and lifespan is affected by high power consumption when driven for a long time.

In the sixth experimental example (Ex6), the driving voltage is improved, and there is a difference of 10.7 Cd/A in green efficiency from the fifth experimental example (Ex5). Green plays an important role in realizing white. Therefore, upon implementing a white-light emitting device, a compensation means, in addition to a light emitting device, is required to obtain the desired white luminance.

In contrast, in the light emitting device of the present invention, in the seventh experimental example (Ex7), efficiency is improved to a level comparable to the fifth experimental example (Ex5), and the driving voltage is comparable to the sixth experimental example (Ex6) having the same layered structure, but green efficiency is improved by 11.5 Cd/A or more. It can be seen that efficiency can be improved even at a decreased driving voltage when a white-light emitting device is implemented. This means that the device can be driven at a low driving voltage for a long period of time, which directly affects the improvement in lifespan.

Hereinafter, another example of the light emitting device of the present invention will be described.

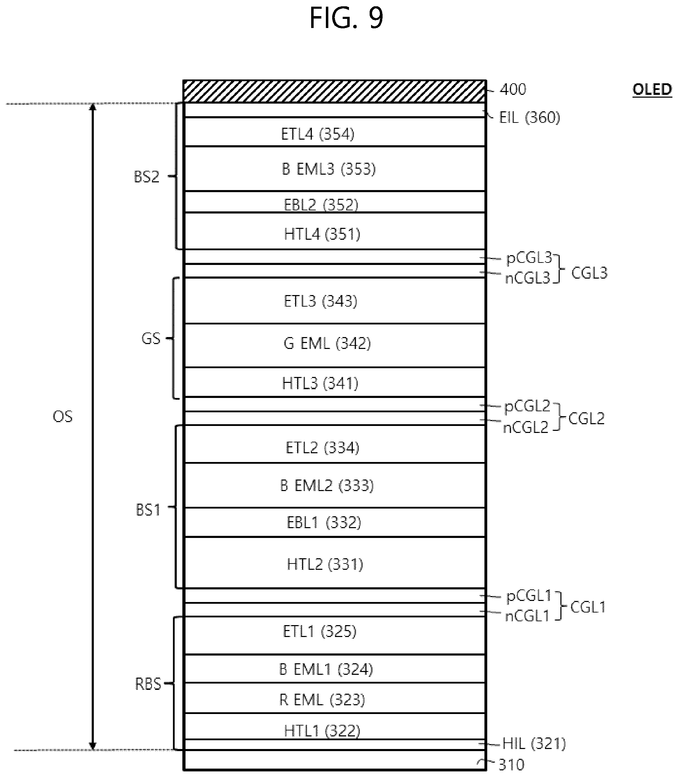

FIG. 9 is a cross-sectional view illustrating a light emitting device according to another embodiment of the present invention.

As shown in FIG. 9, a red-blue stack RBS of an internal stack OS between a first electrode 310 and a second electrode 400 in the light emitting device according to another embodiment of the present invention includes a first blue light emitting layer (B EML1) 324 in contact with a red light emitting layer (R EML) 323, a first electron transport layer (ETL1) 325 disposed thereon, and a first hole transport layer (HTL1) 322 disposed under the red light emitting layer (R EML) 323, in contrast with the light emitting device of FIG. 7. The light emitting device further includes the blue light emitting layer 324 in contact with the red light emitting layer 323, which is the phosphorescent light emitting layer, to satisfy the requirement to improve the color temperature.

In this case, the first and second blue stacks BS1 and BS2 include hole transport layers (HTL2, HTL4) 331 and 351, electron-blocking layers (EBL1, EBL2) 332 and 352, blue light emitting layers (B EML2, B EML3) 333 and 353, and electron transport layers (ETL2, ETL4) 334 and 354, respectively. The second blue stack BS2 in contact with the second electrode 400 further includes an electron injection layer (EIL) 360.

In addition, as described with reference to FIG. 7, the green stack GS has a simple configuration including a hole transport layer (HTL3) 341, a green light emitting layer (G EML) 342, and an electron transport layer (ETL3) 343. As described above, the green stack GS is driven through a simple configuration and is capable of exerting effects of improving efficiency, reducing the driving voltage, and prolonging the lifespan by changing the materials of the hole-transporting host in the hole transport layer 341 and electron-transporting host in the green light emitting layer 342.

Hereinafter, an example of a light emitting display device using the light emitting device of the present invention will be described.

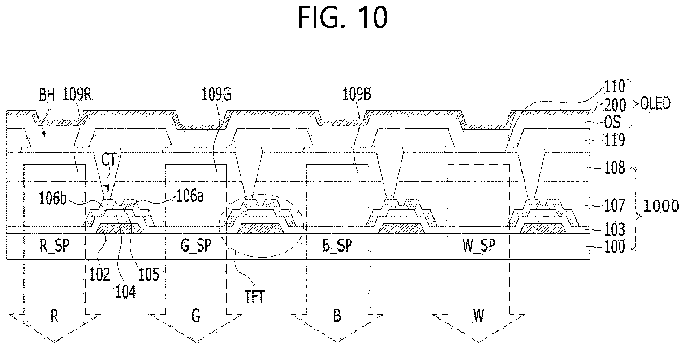

FIG. 10 is a sectional view illustrating the light emitting display device using the light emitting device according to an embodiment of the present invention.

As shown in FIG. 10, the light emitting display device of the present invention includes a substrate 100 having a plurality of subpixels R_SP, G_SP, B_SP, and W_SP emitting red light R, green light G, blue light B and white light W, respectively, a light emitting device (also referred to as an "OLED, organic light emitting diode") commonly provided on the substrate 100, a thin film transistor (TFT) provided at each of the subpixels and connected to the first electrode 110 of the light emitting device (OLED), and a color filter layer 109R, 109G, or 109B provided below the first electrode 110 of at least one of the subpixels.

The illustrated example relates to a configuration including the white subpixel W_SP, but the present invention is not limited thereto. A configuration in which the white subpixel W_SP is omitted and only the red, green, and blue subpixels R_SP, G_SP, and B_SP are provided is also possible. In some cases, a combination of a cyan subpixel, a magenta subpixel, and a yellow subpixel capable of creating white may be used instead of the red, green, and blue subpixels.

The thin film transistor TFT includes, for example, a gate electrode 102, a semiconductor layer 104, and a source electrode 106a and a drain electrode 106b connected to respective sides of the semiconductor layer 104. In addition, a channel passivation layer 105 may be further provided on the portion where the channel of the semiconductor layer 104 is located in order to prevent direct connection between the source/drain electrodes 106a and 106b and the semiconductor layer 104.

A gate insulating layer 103 is provided between the gate electrode 102 and the semiconductor layer 104.

The semiconductor layer 104 may be formed of, for example, an oxide semiconductor, amorphous silicon, polycrystalline silicon, or a combination thereof. For example, when the semiconductor layer 104 is an oxide semiconductor, the heating temperature required for forming the thin film transistor can be lowered, and thus the substrate 100 can be selected from among a greater variety of available types thereof, so the semiconductor layer 104 can be advantageously applied to a flexible display.

In addition, the drain electrode 106b of the thin film transistor TFT may be connected to the first electrode 110 in a contact hole CT formed in the first and second passivation layers 107 and 108.

The first passivation layer 107 is provided to primarily protect the thin film transistor TFT, and color filter layers 109R, 109G, and 109B may be provided thereon.

When the plurality of subpixels includes a red subpixel, a green subpixel, a blue subpixel, and a white subpixel, the color filter layer may include first to third color filter layers 109R, 109G, and 109B in each of the remaining subpixels, excluding the white subpixel W_SP, and may allow the emitted white light to pass through the first electrode 110 for each wavelength. A second passivation layer 108 is formed under the first electrode 110 to cover the first to third color filter layers 109R, 109G, and 109B. The first electrode 110 is formed on the surface of the second passivation layer 108 and connected to the thin film transistor TFT through the contact hole CT.

Here, the configuration beneath the first electrode 110, including the substrate 100, the thin film transistor TFT, the color filter layers 109R, 109G, and 109B, and the first and second passivation layers 107 and 108 is referred to as a "thin film transistor array substrate" 1000.

The light emitting device OLED is formed on the thin film transistor array substrate 1000 including a bank 119 defining a light emitting region BH. The light emitting device (OLED) includes, for example, a transparent first electrode 110, a second electrode 200 of a reflective electrode opposite thereto, and a single green light emitting layer in a green phosphorescent stack between the first electrode 110 and the second electrode 200. As described above, the hole transporting host of the hole transport layer in contact with the green light emitting layer is a biscarbazole compound represented by Formula 2, and the material of the electron-transporting host in the green light emitting layer is a triazine-based compound represented by Formula 1, so effects of improving efficiency, reducing driving voltage and improving lifetime can be obtained.

According to the light emitting device of the present invention and a light emitting display device including the same, a fluorescent stack is connected to a phosphorescent stack to form a light emitting device that realizes white. Among them, the phosphorescent stack shares the use of excitons with other phosphorescent light emitting layers in contact with the same at higher internal quantum efficiency than the fluorescent stack. The light emitting device and the light emitting display device including the same according to the present invention are capable of preventing exciton loss at the interface with the hole transport layer by changing the material of the red light emitting layer between the hole transport layer and the other phosphorescent layer and evenly distributing the generation of excitons in the adjacent phosphorescent layers, thereby uniformly improving the white efficiency of the adjacent phosphorescent layers.

As a result, by balancing the efficiency between the red light emitting layer and the adjacent phosphorescent light emitting layer, the luminance of the phosphorescent light emitting layers in the white-light emitting device can be increased in a balanced way and the efficiency of the light emitting display device can also be improved.

In one embodiment of the present invention, a light emitting device further comprises a red stack, a first blue stack, and a second blue stack sequentially disposed between the first electrode and the second electrode, wherein the light emitting unit is between the first blue stack and the second blue stack. In another aspect of the present invention, a light emitting display device includes a substrate including a plurality of subpixels, a thin film transistor provided at each of the subpixels on the substrate, and the light emitting device of the present invention connected to the thin film transistor.

The light emitting device and the light emitting display device according to the present invention have the following effects.

In a light emitting device having a single light emitting layer in each stack in order to improve luminance, efficiency is improved without forming a separate control layer around a green phosphorescent layer by changing the physical properties of the green phosphorescent layer and the hole transport layer adjacent to the green stack having a single green phosphorescent layer.

In addition, luminance of white is improved by improving the efficiency of the green stack, which contributes most to realizing white. In addition, when the white luminance is improved under the condition that the same voltage is applied, the voltage required to realize a predetermined luminance is reduced, so the turn-on voltage is reduced over time and thus the lifespan is improved.

## Claims

1. A light emitting device comprising:
a first electrode (110) and a second electrode (200) facing each other; and
a light emitting unit comprising a p-type charge generation layer (1105), a hole transport layer (1210), and a green light emitting layer (1220) sequentially stacked,
wherein the green light emitting layer (1220) comprises a first material represented by the following Formula 1 and a phosphorescent dopant, 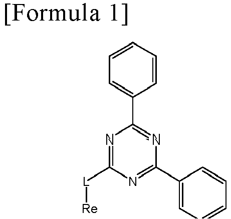
wherein Re is at least one selected from the group consisting of a dibenzofuran group, a dibenzothiophene group, a triphenyl group, a triphenylene group, a carbazole group, a benzocarbazole group, a biscarbazole group, a fluorene group, an indenocarbazole and a phenyl-carbazole group;
L is a single bond or at least one selected from the group consisting of a phenyl group, a phenylene group, a biphenyl group, a biphenylene group, a dibenzofuran group, a dibenzofurylene group, a dibenzothiophene group, and a dibenzothienylene group,
**characterized in that**
the hole transport layer (1210) comprises a second material of Formula 2: 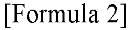 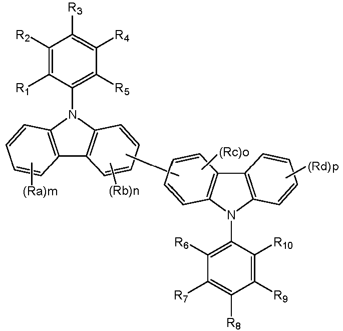
wherein Ra to Rd are each independently selected from hydrogen, deuterium, halogen, a substituted or unsubstituted C1-C6 alkyl group, a substituted or unsubstituted C3-C6 cycloalkyl group, a substituted or unsubstituted C6-C15 aryl group, a substituted or unsubstituted C5-C9 heteroaryl group, a carbazole group, a dibenzofuran group, a dibenzothiophene group, a trialkylsilyl group, and a triarylsilyl group;
m and p are each independently selected from integers from 0 to 4;
n and o are each independently selected from integers from 0 to 3; and
R₁ to R₁₀ are each independently selected from hydrogen, deuterium, halogen, a substituted or unsubstituted C1-C6 alkyl group, a substituted or unsubstituted C6-C18 aryl group, a carbazole group, a phenyl-carbazole group, a dibenzofuran group, and a dibenzothiophene group; or two or more of R₁ to R₁₀ together with the p henyl group that they are connected with may form a condensed aryl group.

2. The light emitting device according to claim 1, wherein the material of Formula 1 is one of the following compounds TRZ-01 to TRZ-27:

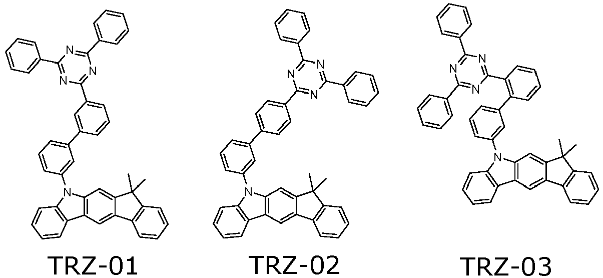

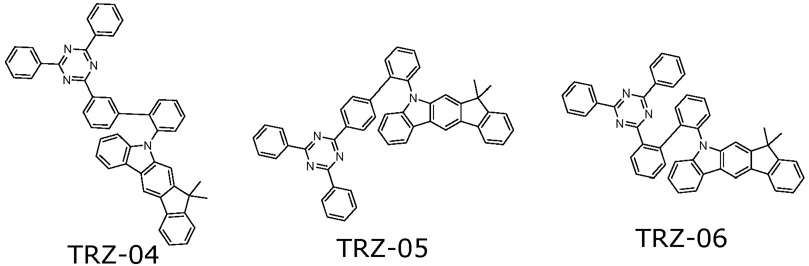

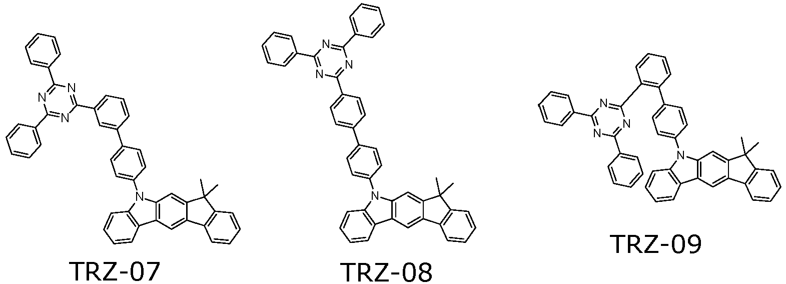

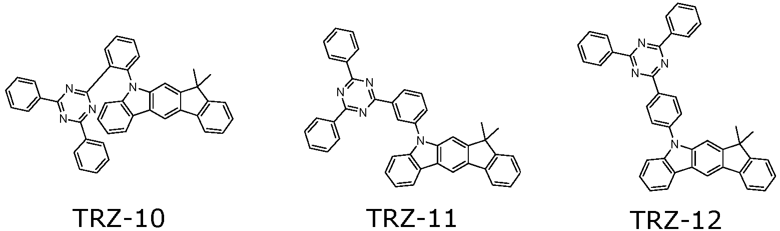

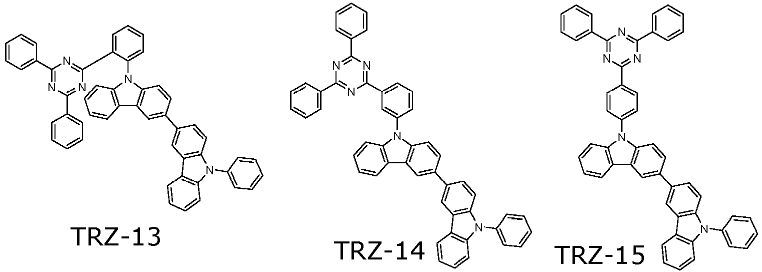

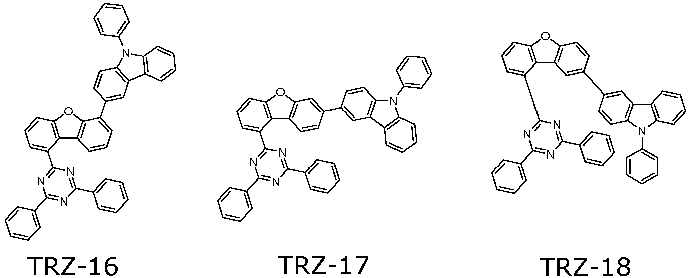

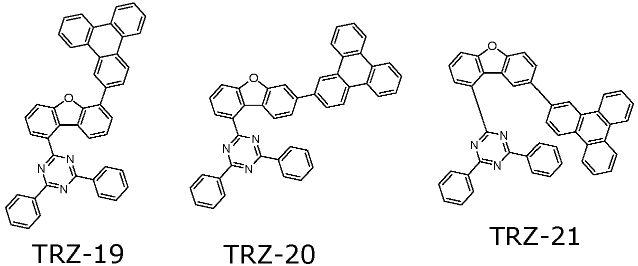

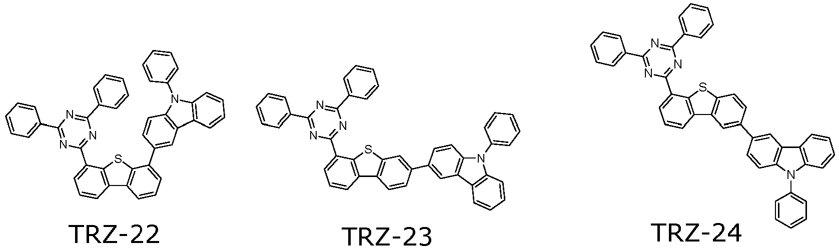

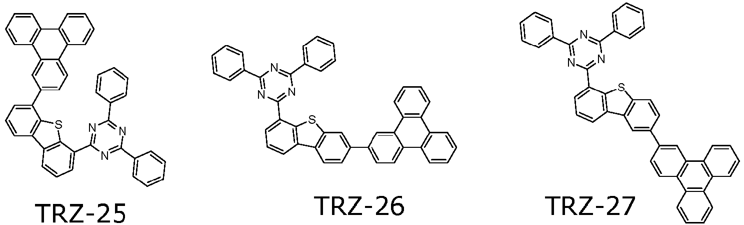

3. The light emitting device according to claim 1 or 2, wherein in Formula 2 m, n, o, p are 0, four of R₁ to R₅ are independently of each other hydrogen, deuterium or halogen and one of R₁ to R₅ is a phenyl group, a biphenyl group, a dibenzofuran group, a dibenzothiophene group, a carbazole group or a phenyl-carbazole group, at least one of R₆ to R₁₀ are hydrogen, deuterium or halogen and at most four of R₆ to R₁₀ are independently of each other hydrogen, a phenyl group, a triphenylene group, a phenanthrene group, an anthracene group, a naphthyl group, or two or more of R₆ to R₁₀ together with the phenyl group that they are connected with may form a condensed aryl group, wherein the condensed aryl group is preferably a naphthyl group, a phenanthrene group, or a triphenylene group.

4. The light emitting device according to anyone of claims 1 to 3, wherein the material of Formula 2 is one of the following compounds BCA-01 to BCA-44:

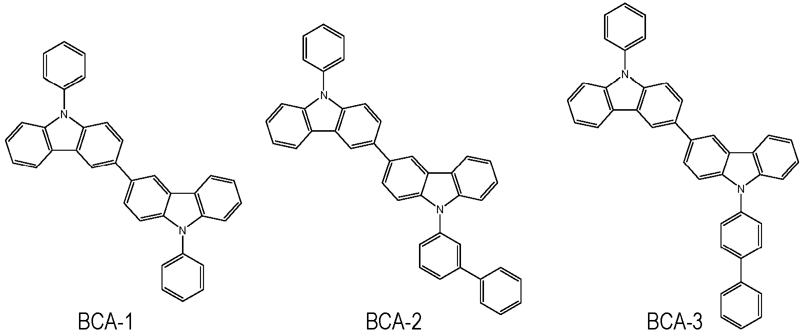

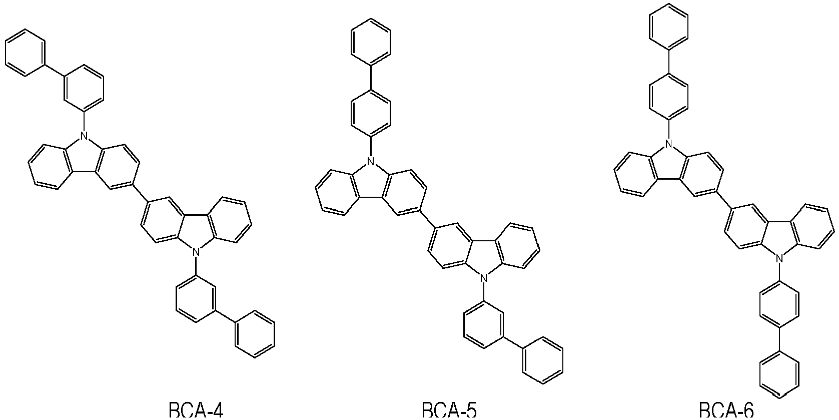

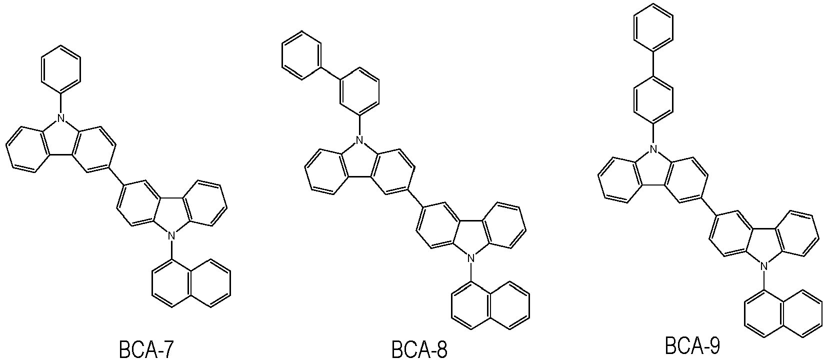

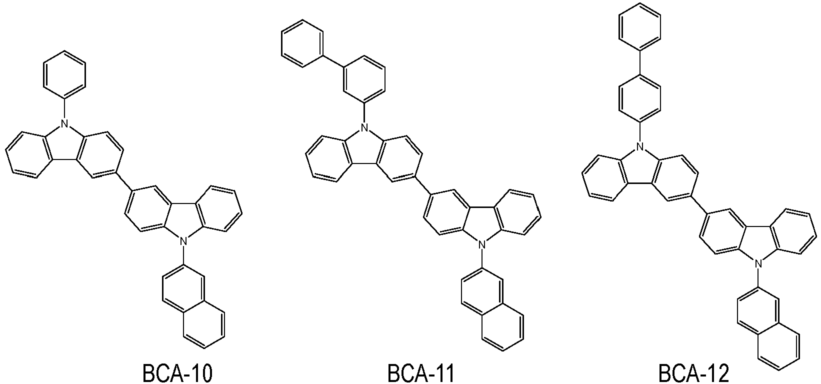

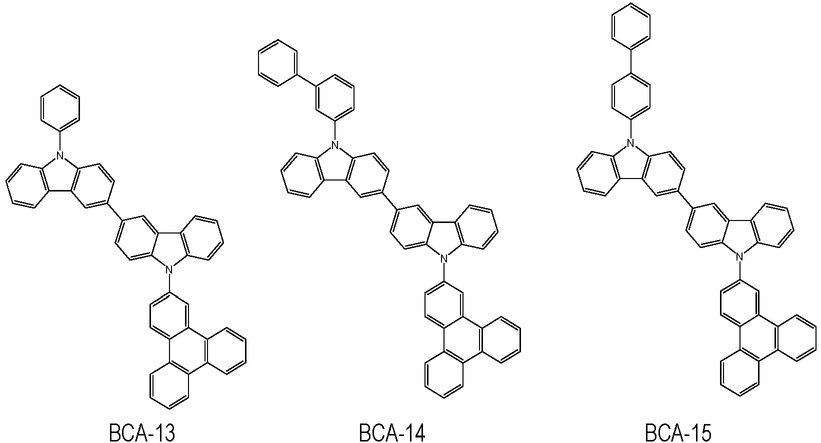

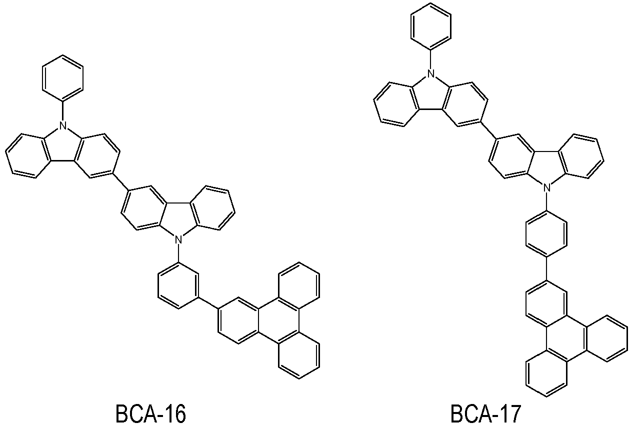

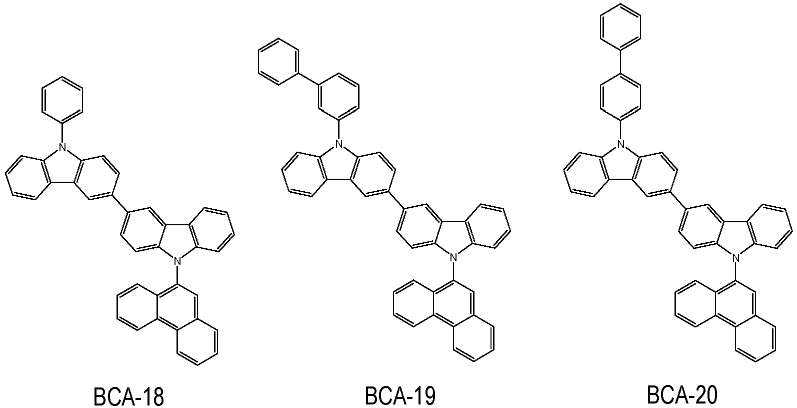

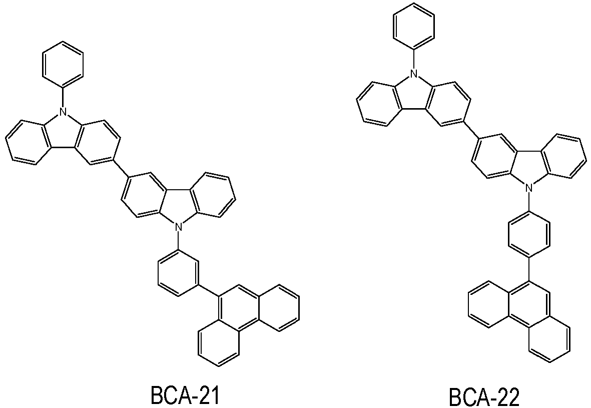

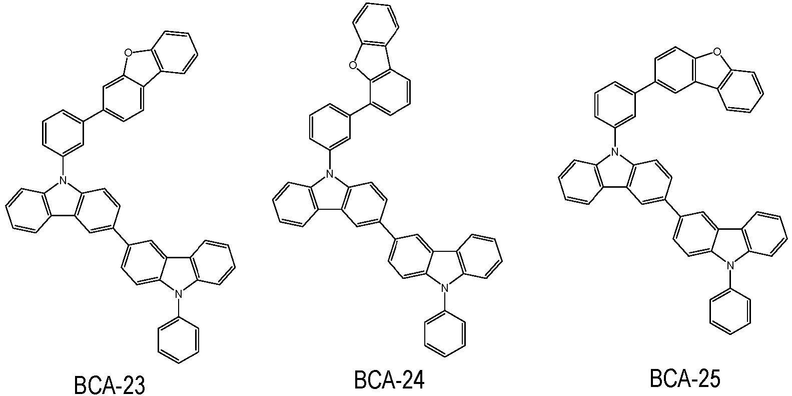

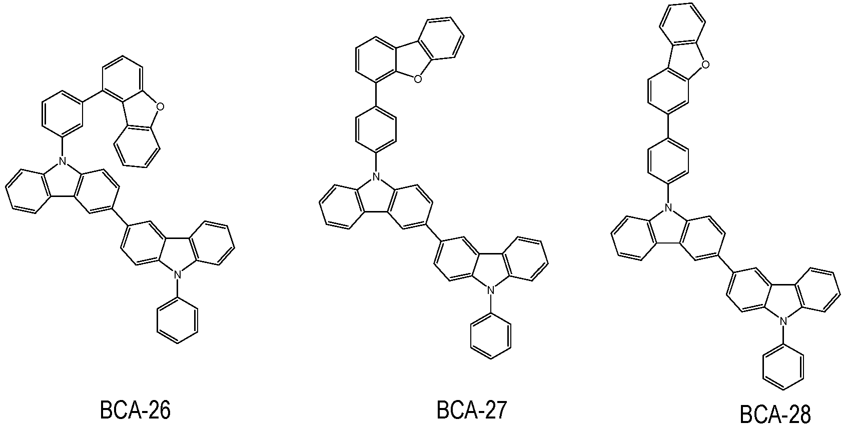

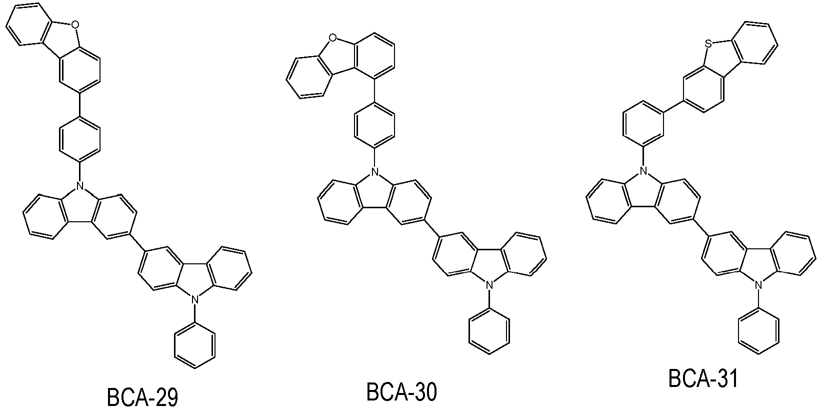

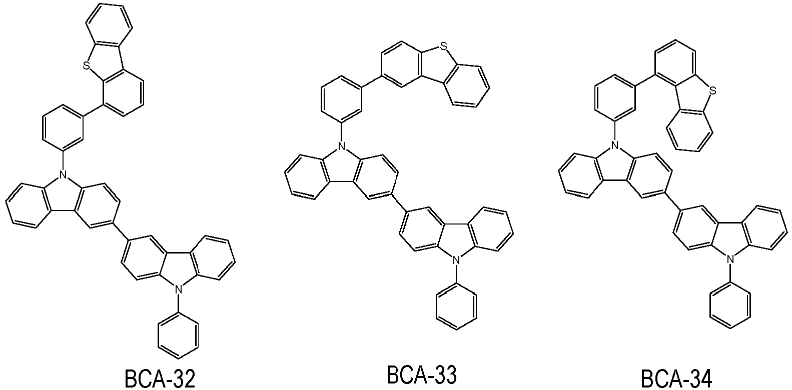

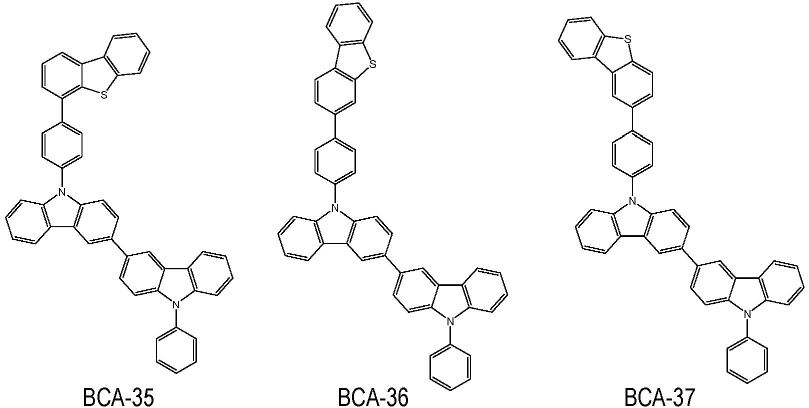

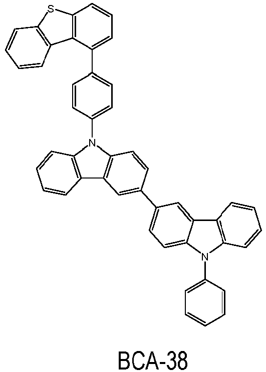

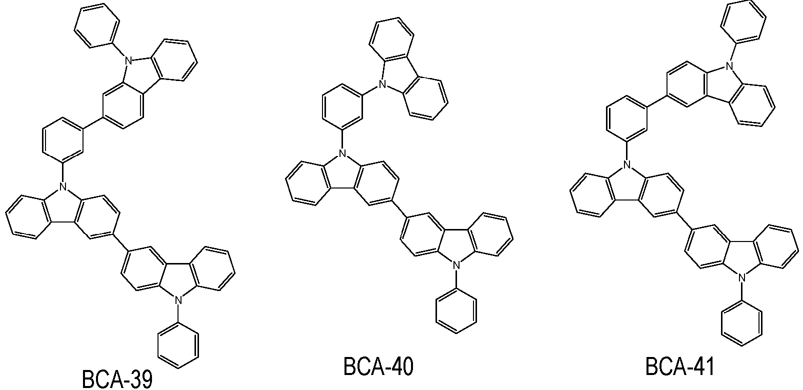

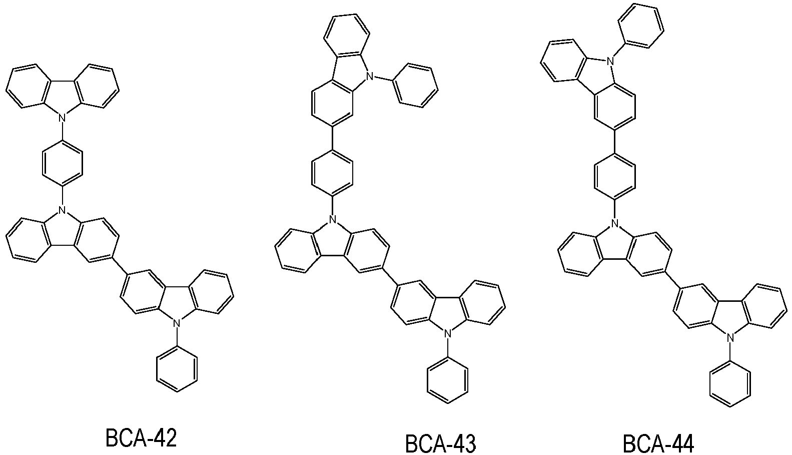

5. The light emitting device according to any of claims 1 to 4, wherein the phosphorescent dopant is a metal complex compound having an emission peak of a wavelength 510 nm to 550 nm.

6. The light emitting device according to any of claims 1 to 5, wherein a side of the green light emitting layer (1220) that is not in contact with the hole transport layer (1210) is in contact with an electron transport layer (1230).

7. The light emitting device according to any of claims 1 to 6, wherein a side of the electron transport layer (1230) that is not in contact with the green light emitting layer (1220) is in contact with an electron injection layer or an n-type charge generation layer.

8. The light emitting device according to claim 7, wherein an organic layer doped with a metal or an inorganic layer containing a metal compound is in contact with the side of the electron transport layer (1230) that is not in contact with the green light emitting layer (1220).

9. The light emitting device according to claim 7, wherein at least one of the p-type charge generation layer (1105) and the n-type charge generation layer is adjacent to a blue stack including a blue light emitting layer, and
the blue light emitting layer comprises a blue dopant having an emission peak of a wavelength 420 nm to 480 nm.

10. The light emitting device according to any of claims 1 to 9, wherein the p-type charge generation layer (1105) is spaced at a distance of 50 nm or more from the first electrode.

11. The light emitting device according to any of claims 1-8 and 10, further comprising
a red stack, a first blue stack, and a second blue stack sequentially disposed between the first electrode and the second electrode,
wherein the light emitting unit is between the first blue stack and the second blue stack.

12. A light emitting display device comprising:
a substrate (100) comprising a plurality of subpixels;
a thin film transistor provided at each of the subpixels on the substrate; and the light emitting device according to any one of claims 1 to 11, connected to the thin film transistor.

## Patentansprüche

1. Lichtemittierende Vorrichtung, umfassend:
eine erste Elektrode (110) und eine zweite Elektrode (200), die einander gegenüberliegen; und
eine lichtemittierende Einheit, die eine p-Typ-Ladungserzeugungsschicht (1105), eine Lochtransportschicht (1210) und eine grünes Licht emittierende Schicht (1220) umfasst, die aufeinander gestapelt sind,
wobei die grünes Licht emittierende Schicht (1220) ein erstes Material, dargestellt durch die folgende Formel 1, und einen phosphoreszierenden Dotierstoff umfasst, 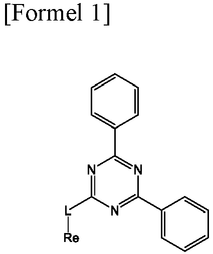
worin Re mindestens eines ist, ausgewählt aus der Gruppe bestehend aus einer Dibenzofurangruppe, einer Dibenzothiophengruppe, einer Triphenylgruppe, einer Triphenylengruppe, einer Carbazolgruppe, einer Benzocarbazolgruppe, einer Biscarbazolgruppe, einer Fluorengruppe, einem Indenocarbazol und einer Phenylcarbazolgruppe;
L eine Einfachbindung oder mindestens eines ist, ausgewählt aus der Gruppe bestehend aus einer Phenylgruppe, einer Phenylengruppe, einer Biphenylgruppe, einer Biphenylengruppe, einer Dibenzofurangruppe, einer Dibenzofurylengruppe, einer Dibenzothiophengruppe und einer Dibenzothienylengruppe,
**dadurch gekennzeichnet, dass** die Lochtransportschicht (1210) ein zweites Material der Formel 2 umfasst: 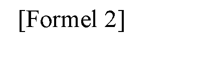 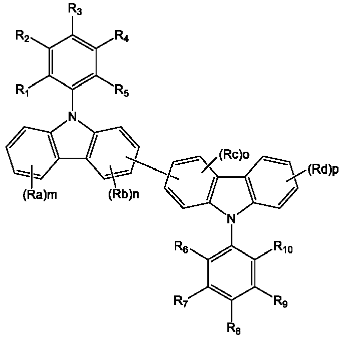
worin Ra bis Rd jeweils unabhängig voneinander ausgewählt sind aus Wasserstoff, Deuterium, Halogen, einer substituierten oder unsubstituierten C1-C6-Alkylgruppe, einer substituierten oder unsubstituierten C3-C6-Cycloalkylgruppe, einer substituierten oder unsubstituierten C6-C15-Arylgruppe, einer substituierten oder unsubstituierten C5-C9-Heteroarylgruppe, einer Carbazolgruppe, einer Dibenzofurangruppe, einer Dibenzothiophengruppe, einer Trialkylsilylgruppe und einer Triarylsilylgruppe;
m und p jeweils unabhängig voneinander aus ganzen Zahlen von 0 bis 4 ausgewählt sind;
n und o jeweils unabhängig voneinander aus ganzen Zahlen von 0 bis 3 ausgewählt sind; und
R₁ bis R₁₀ jeweils unabhängig voneinander aus Wasserstoff, Deuterium, Halogen, einer substituierten oder unsubstituierten C1-C6-Alkylgruppe, einer substituierten oder unsubstituierten C6-C18-Arylgruppe, einer Carbazolgruppe, einer Phenylcarbazolgruppe, einer Dibenzofurangruppe und einer Dibenzothiophengruppe ausgewählt sind; oder zwei oder mehr von R₁ bis R₁₀ zusammen mit der Phenylgruppe, mit der sie verbunden sind, eine kondensierte Arylgruppe bilden können.

2. Lichtemittierende Vorrichtung nach Anspruch 1, wobei das Material der Formel 1 eine der folgenden Verbindungen TRZ-01 bis TRZ-27 ist:

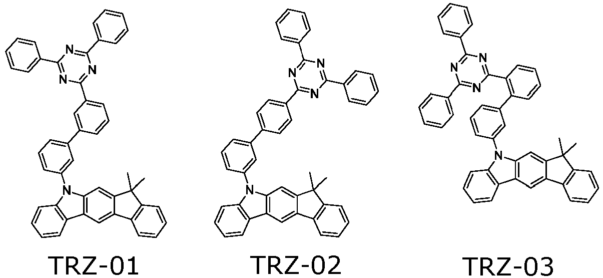

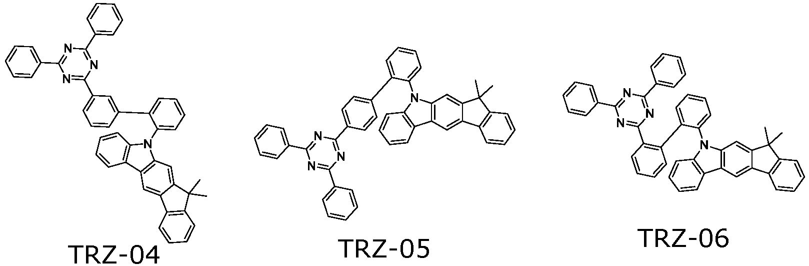

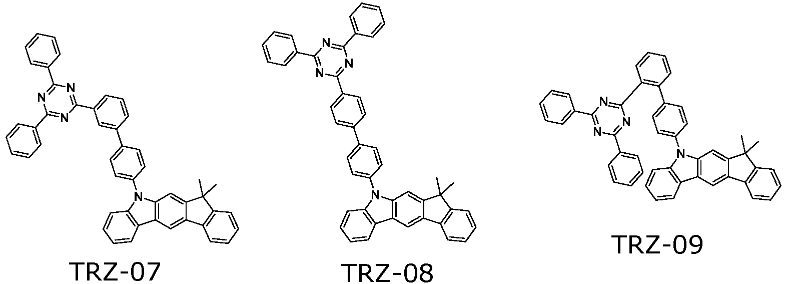

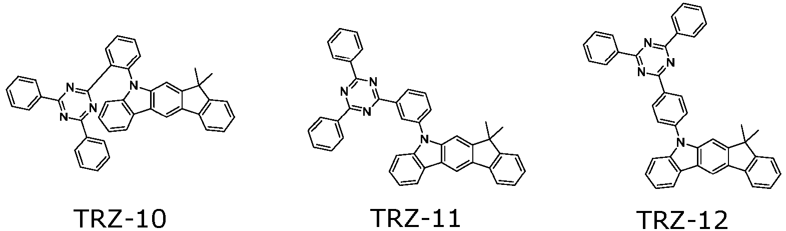

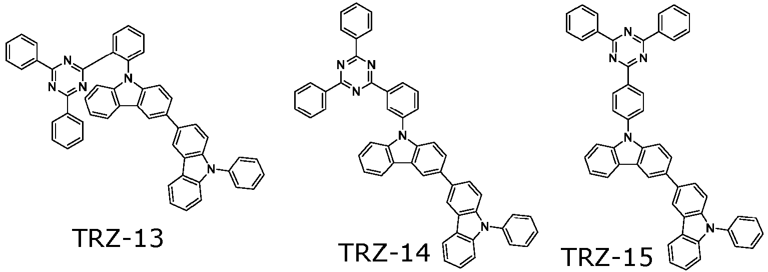

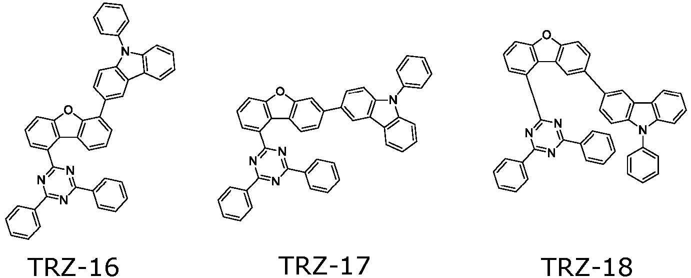

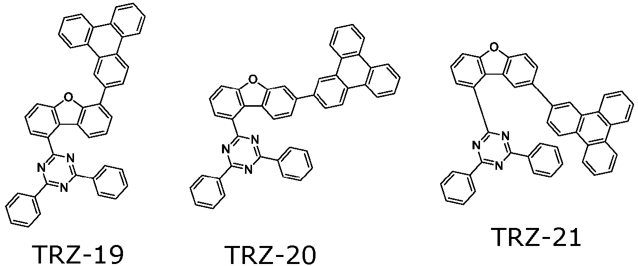

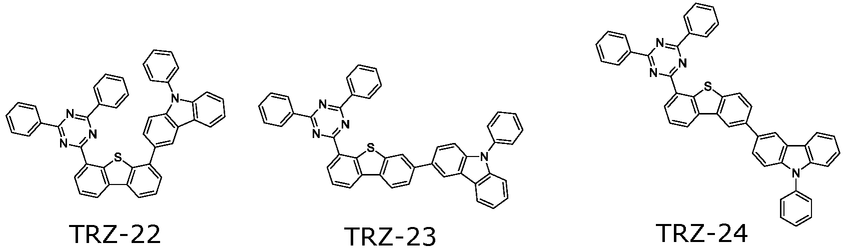

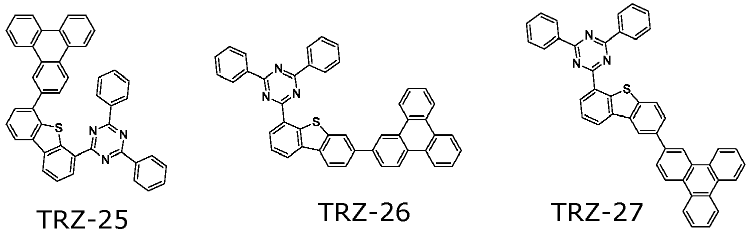

3. Lichtemittierende Vorrichtung nach Anspruch 1 oder 2, wobei in Formel 2 m, n, o, p 0 sind, vier von R₁ bis R₅ unabhängig voneinander Wasserstoff, Deuterium oder Halogen sind und einer von R₁ bis R₅ eine Phenylgruppe, eine Biphenylgruppe, eine Dibenzofurangruppe, eine Dibenzothiophengruppe, eine Carbazolgruppe oder eine Phenylcarbazolgruppe ist, mindestens einer von R₆ bis R₁₀ Wasserstoff, Deuterium oder Halogen ist und höchstens vier von R₆ bis R₁₀ unabhängig voneinander Wasserstoff, eine Phenylgruppe, eine Triphenylengruppe, eine Phenanthrengruppe, eine Anthracengruppe, eine Naphthylgruppe sind, oder zwei oder mehr von R₆ bis R₁₀ zusammen mit der Phenylgruppe, mit der sie verbunden sind, eine kondensierte Arylgruppe bilden können, wobei die kondensierte Arylgruppe bevorzugt eine Naphthylgruppe, eine Phenanthrengruppe oder eine Triphenylengruppe ist.

4. Lichtemittierende Vorrichtung nach einem der Ansprüche 1 bis 3, wobei das Material der Formel 2 eine der folgenden Verbindungen BCA-01 bis BCA-44 ist:

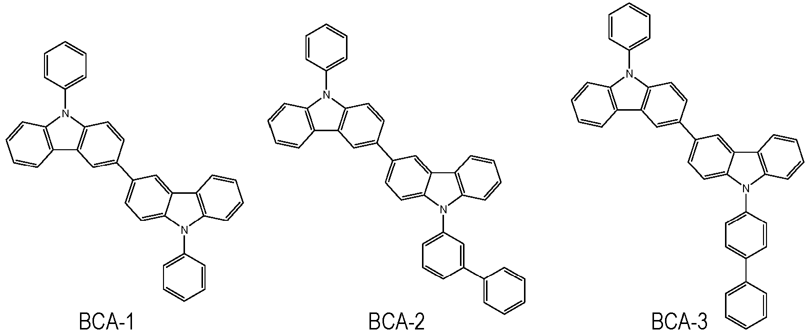

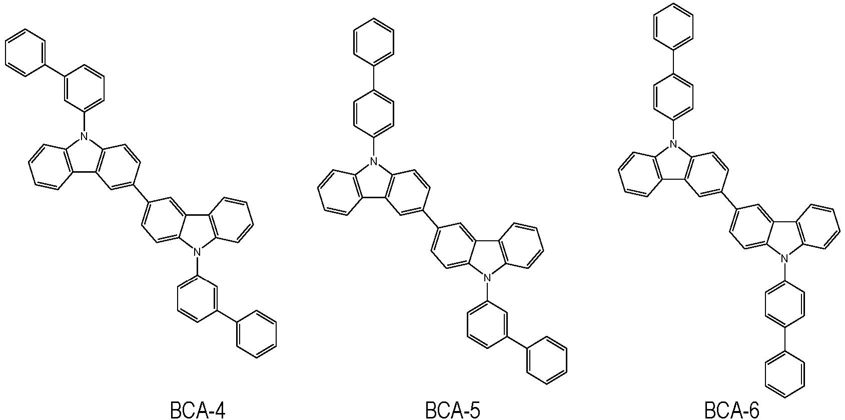

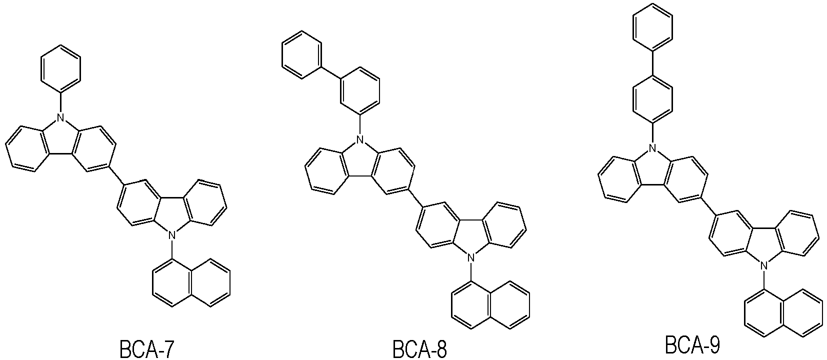

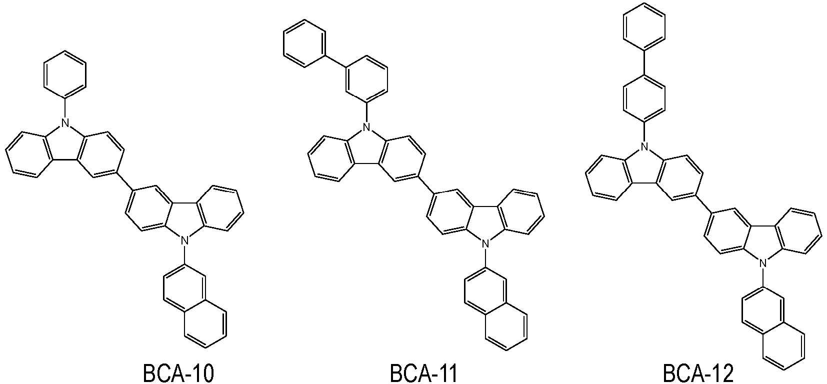

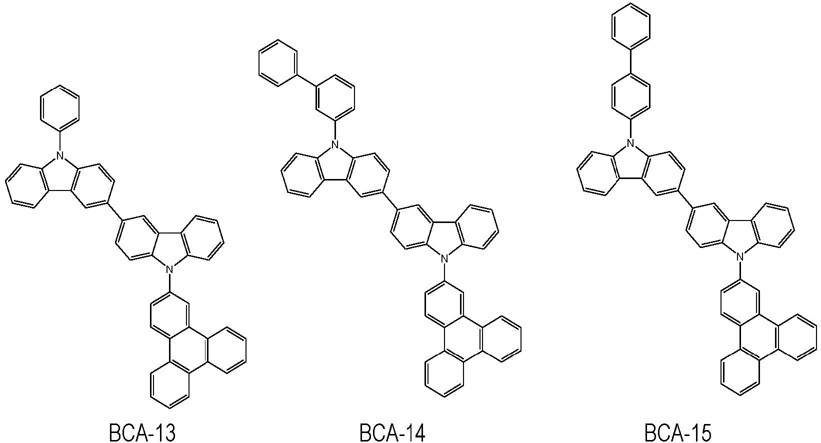

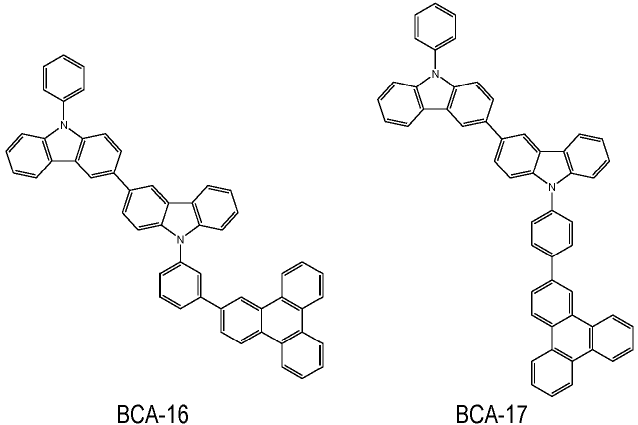

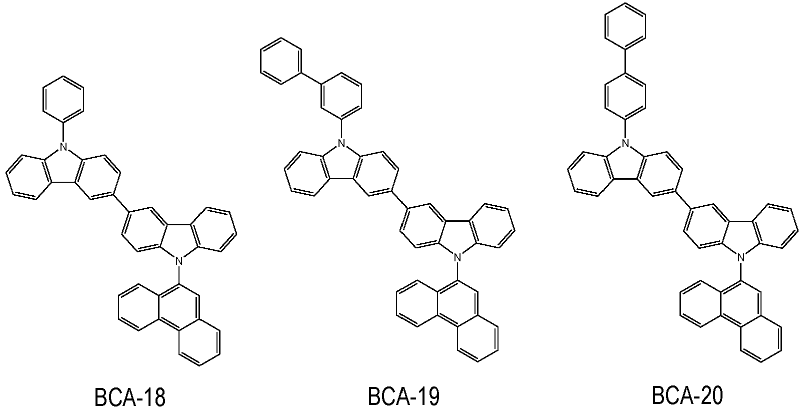

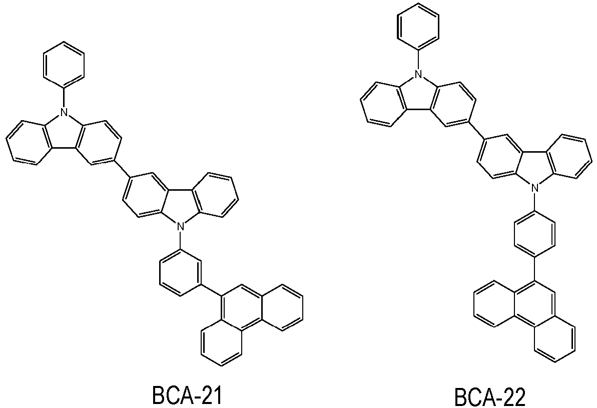

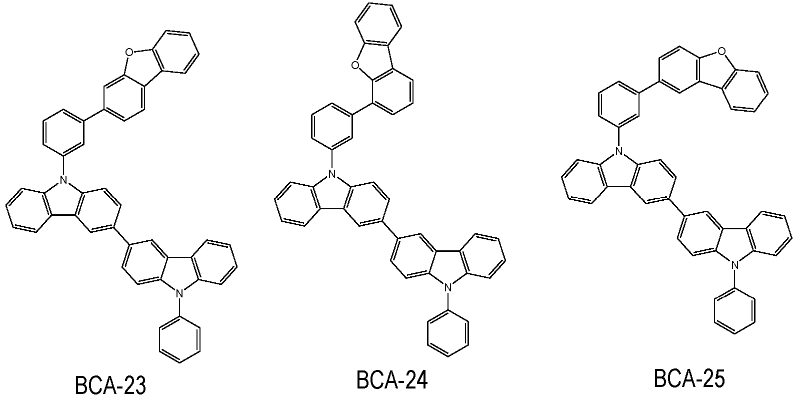

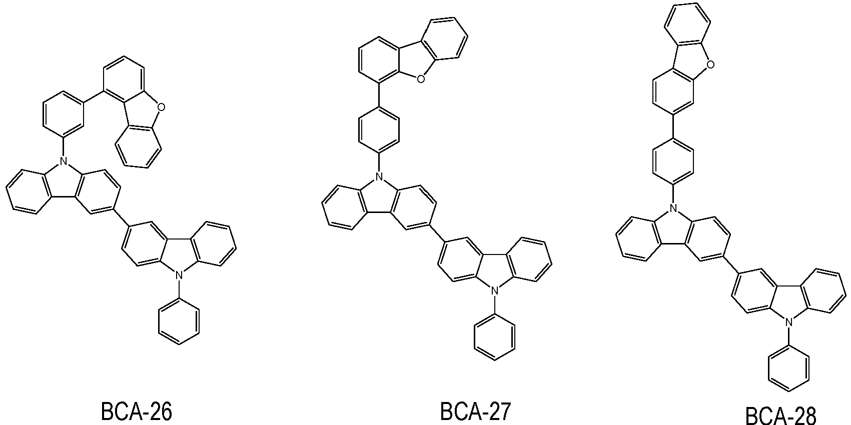

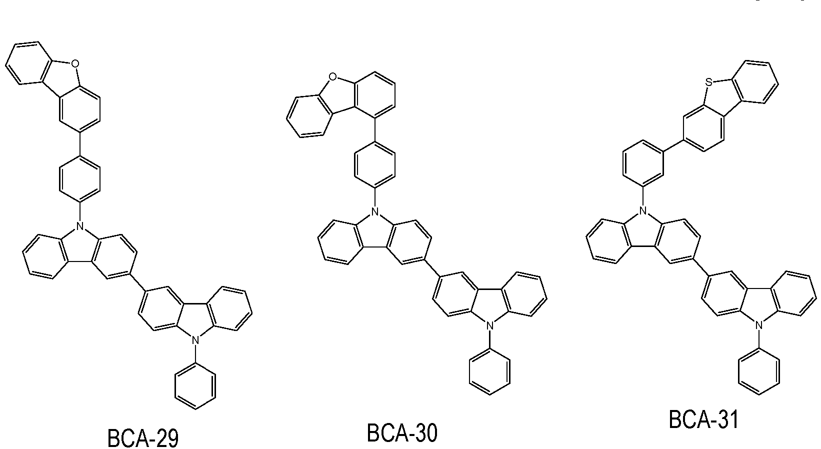

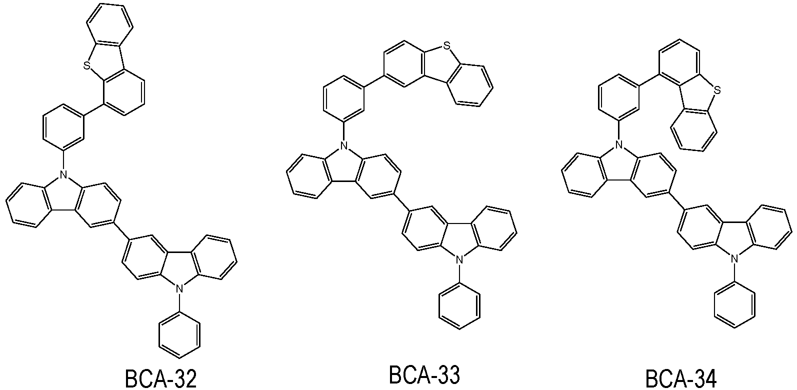

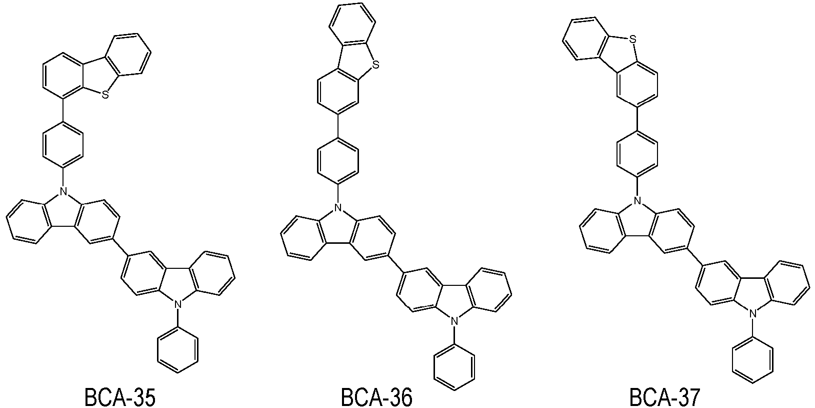

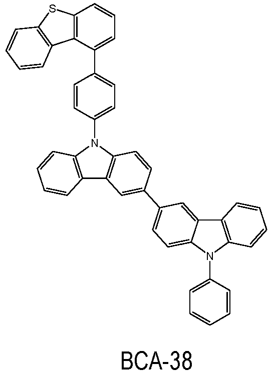

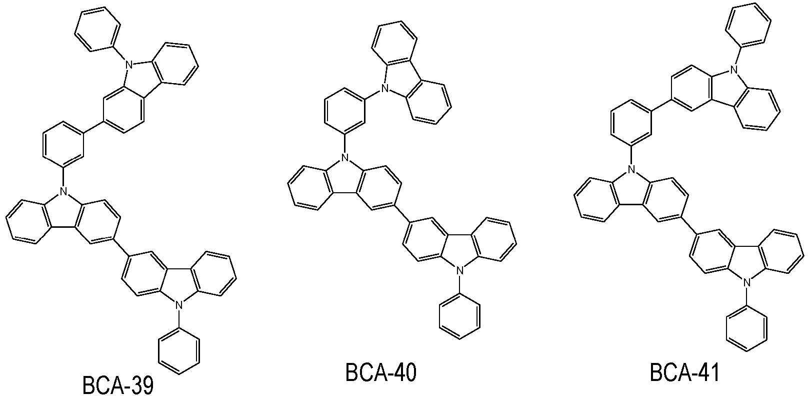

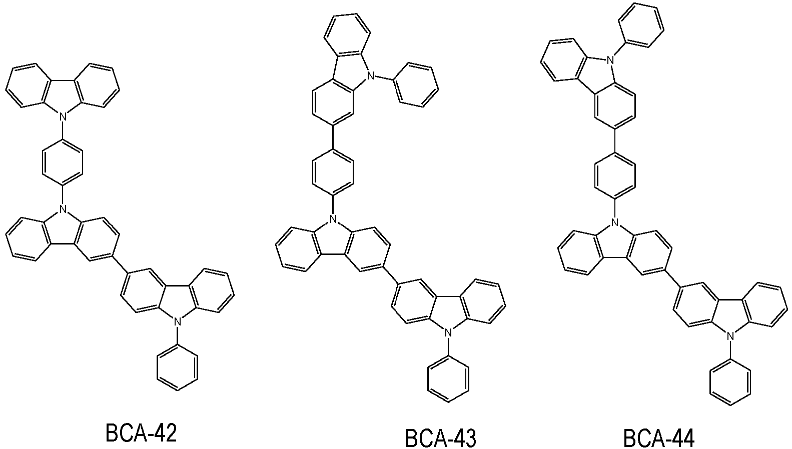

5. Lichtemittierende Vorrichtung nach einem der Ansprüche 1 bis 4, wobei der phosphoreszierende Dotierstoff eine Metallkomplexverbindung mit einem Emissionspeak bei einer Wellenlänge von 510 nm bis 550 nm ist.

6. Lichtemittierende Vorrichtung nach einem der Ansprüche 1 bis 5, wobei eine Seite der grünes Licht emittierenden Schicht (1220), die nicht in Kontakt mit der Lochtransportschicht (1210) ist, in Kontakt mit einer Elektronentransportschicht (1230) ist.

7. Lichtemittierende Vorrichtung nach einem der Ansprüche 1 bis 6, wobei eine Seite der Elektronentransportschicht (1230), die nicht in Kontakt mit der grünes Licht emittierenden Schicht (1220) ist, in Kontakt mit einer Elektroneninjektionsschicht oder einer n-Typ-Ladungserzeugungsschicht ist.

8. Lichtemittierende Vorrichtung nach Anspruch 7, wobei eine organische Schicht, die mit einem Metall dotiert ist, oder eine anorganische Schicht, die eine Metallverbindung enthält, in Kontakt mit der Seite der Elektronentransportschicht (1230) steht, die nicht in Kontakt mit der grünes Licht emittierenden Schicht (1220) steht.

9. Lichtemittierende Vorrichtung nach Anspruch 7, wobei mindestens eine der p-Typ-Ladungserzeugungsschicht (1105) und der n-Typ-Ladungserzeugungsschicht an einen blauen Stapel angrenzt, der eine blaues Licht emittierende Schicht enthält, und
die blaues Licht emittierende Schicht einen blauen Dotierstoff mit einem Emissionspeak bei einer Wellenlänge von 420 nm bis 480 nm umfasst.

10. Lichtemittierende Vorrichtung nach einem der Ansprüche 1 bis 9, wobei die p-Typ-Ladungserzeugungsschicht (1105) in einem Abstand von 50 nm oder mehr von der ersten Elektrode beabstandet ist.

11. Lichtemittierende Vorrichtung nach einem der Ansprüche 1-8 und 10, ferner umfassend einen roten Stapel, einen ersten blauen Stapel und einen zweiten blauen Stapel, die aufeinanderfolgend zwischen der ersten Elektrode und der zweiten Elektrode angeordnet sind,
wobei die lichtemittierende Einheit zwischen dem ersten blauen Stapel und dem zweiten blauen Stapel liegt.

12. Lichtemittierende Anzeigevorrichtung, umfassend:
ein Substrat (100), umfassend eine Vielzahl von Subpixeln;
einen Dünnschichttransistor, der an jedem der Subpixel auf dem Substrat vorgesehen ist; und
die lichtemittierende Vorrichtung nach einem der Ansprüche 1 bis 11, die mit dem Dünnschichttransistor verbunden ist.

## Revendications

1. Dispositif électroluminescent comportant :
une première électrode (110) et une seconde électrode (200) dirigées l'une vers l'autre ; et
une unité électroluminescente comportant une couche de génération de charges de type p (1105), une couche de transport de trous (1210) et une couche d'émission de lumière verte (1220) empilées séquentiellement,
dans lequel la couche d'émission de lumière verte (1220) comporte un premier matériau représenté par la Formule 1 suivante et un dopant phosphorescent, 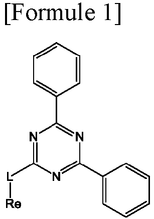
dans laquelle Re est au moins un élément choisi parmi le groupe constitué d'un groupe dibenzofurane, d'un groupe dibenzothiophène, d'un groupe triphényle, d'un groupe triphénylène, d'un groupe carbazole, d'un groupe benzocarbazole, d'un groupe biscarbazole, d'un groupe fluorène, d'un groupe indénocarbazole et d'un groupe phényl-carbazole ;
L est une liaison simple ou au moins un élément choisi parmi le groupe constitué d'un groupe phényle, d'un groupe phénylène, d'un groupe biphényle, d'un groupe biphénylène, d'un groupe dibenzofurane, d'un groupe dibenzofurylène, d'un groupe dibenzothiophène et d'un groupe dibenzothiénylène,
**caractérisé en ce que** la couche de transport de trous (1210) comporte un second matériau de Formule 2 : 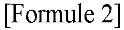 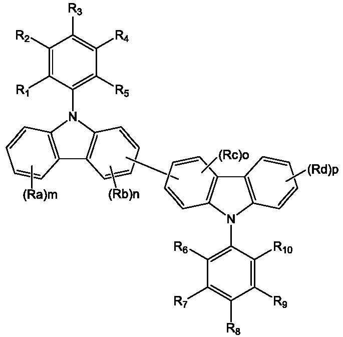
dans laquelle Ra à Rd sont choisis chacun, indépendamment les uns des autres, parmi l'hydrogène, le deutérium, un halogène, un groupe alkyle en C₁ à C₆ substitué ou non substitué, un groupe cycloalkyle en C₃ à C₆ substitué ou non substitué, un groupe aryle en C₆ à C₁₅ substitué ou non substitué, un groupe hétéroaryle en C₅ à C₉ substitué ou non substitué, un groupe carbazole, un groupe dibenzofurane, un groupe dibenzothiophène, un groupe trialkylsilyle et un groupe triarylsilyle ;
m et p sont choisis chacun, indépendamment l'un de l'autre, parmi des entiers de 0 à 4 ;
n et o sont choisis chacun, indépendamment l'un de l'autre, parmi des entiers de 0 à 3 ; et
R₁ à R₁₀ sont choisis chacun, indépendamment les uns des autres, parmi l'hydrogène, le deutérium, un halogène, un groupe alkyle en C₁ à C₆ substitué ou non substitué, un groupe aryle en C₆ à C₁₈ substitué ou non substitué, un groupe carbazole, un groupe phényl-carbazole, un groupe dibenzofurane et un groupe dibenzothiophène ; ou deux éléments ou plus parmi R₁ à R₁₀ en association avec le groupe phényle auquel ils sont liés peuvent former un groupe aryle condensé.

2. Dispositif électroluminescent selon la revendication 1, dans lequel le matériau de Formule 1 est l'un des composés TRZ-01 à TRZ-27 suivants :

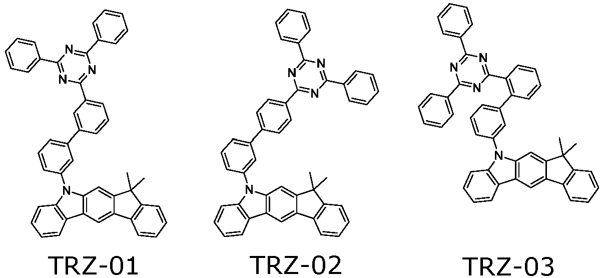

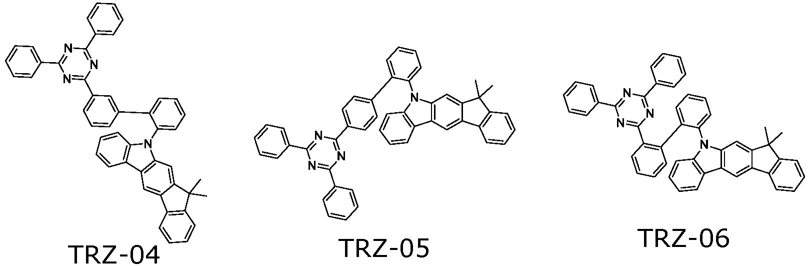

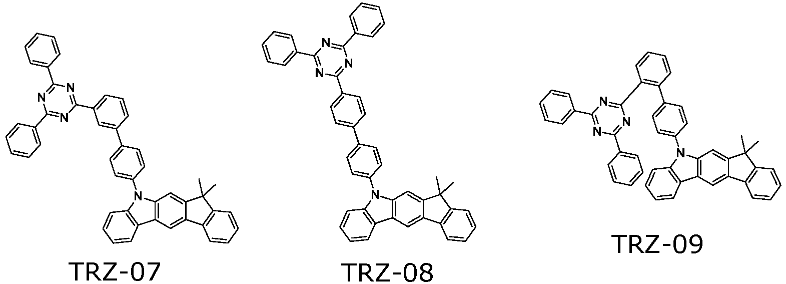

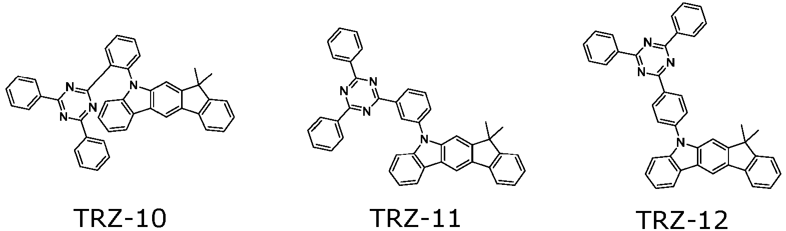

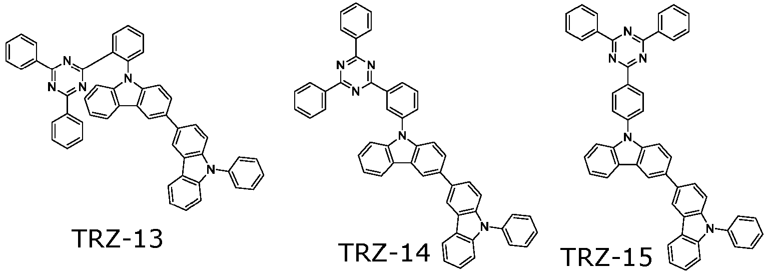

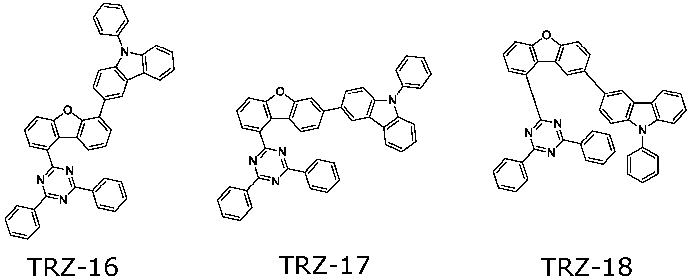

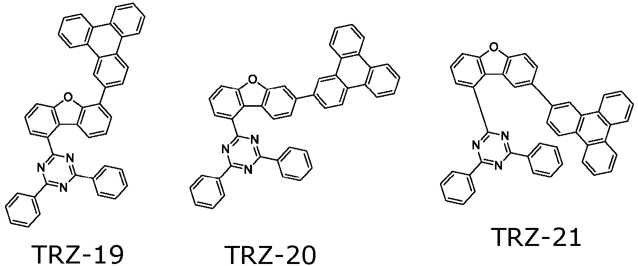

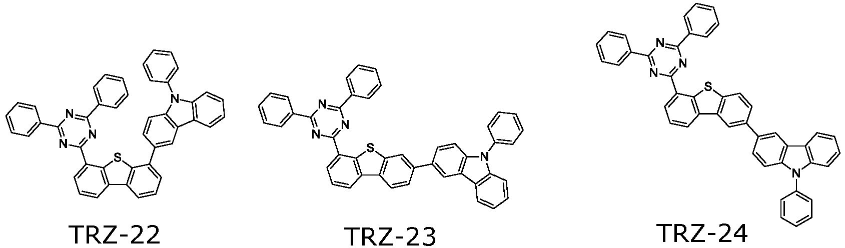

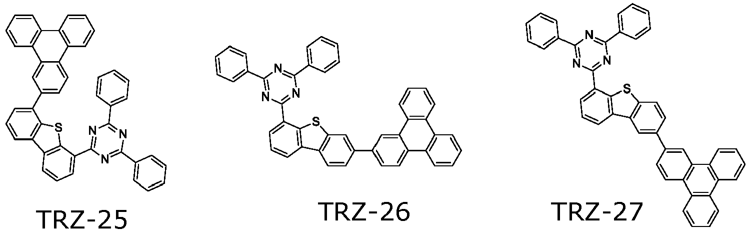

3. Dispositif électroluminescent selon la revendication 1 ou 2, dans lequel, dans la Formule 2, m, n, o, p sont égaux à 0, quatre éléments parmi R₁ à R₅ sont, indépendamment les uns des autres, l'hydrogène, le deutérium ou un halogène, et un élément parmi R ₁ à R ₅ est un groupe phényle, un groupe biphényle, un groupe dibenzofurane, un groupe dibenzothiophène, un groupe carbazole ou un groupe phényl-carbazole, au moins un élément parmi R₆ à R ₁₀ est l'hydrogène, le deutérium ou un halogène et au plus quatre éléments parmi R₆ à R₁₀ sont, indépendamment les uns des autres, l'hydrogène, un groupe phényle, un groupe triphénylène, un groupe phénanthrène, un groupe anthracène, un groupe naphtyle, ou deux éléments ou plus parmi R₆ à R₁₀ en association avec le groupe phényle auquel ils sont liés peuvent former un groupe aryle condensé, dans lequel le groupe aryle condensé est de préférence un groupe naphtyle, un groupe phénanthrène ou un groupe triphénylène.

4. Dispositif électroluminescent selon l'une quelconque des revendications 1 à 3, dans lequel le matériau de Formule 2 est l'un des composés BCA-01 à BCA-44 suivants :

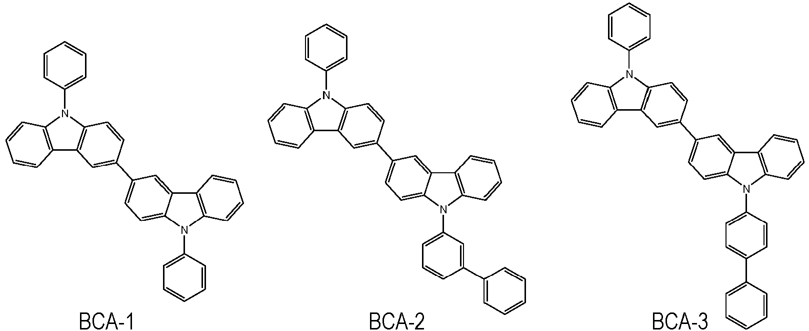

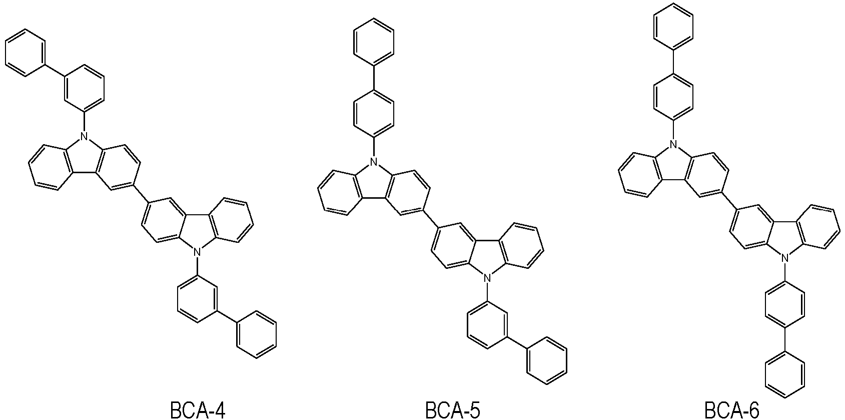

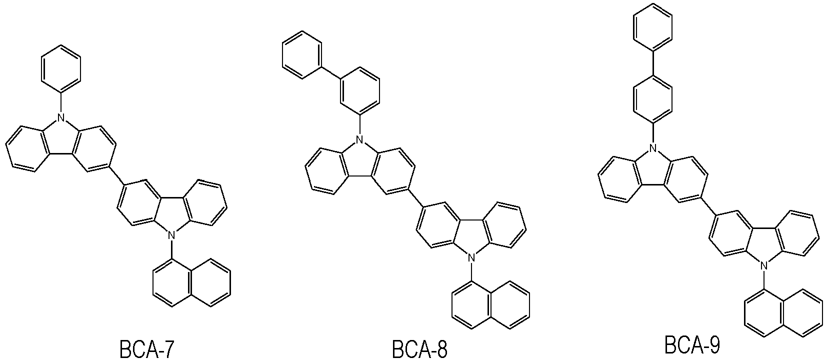

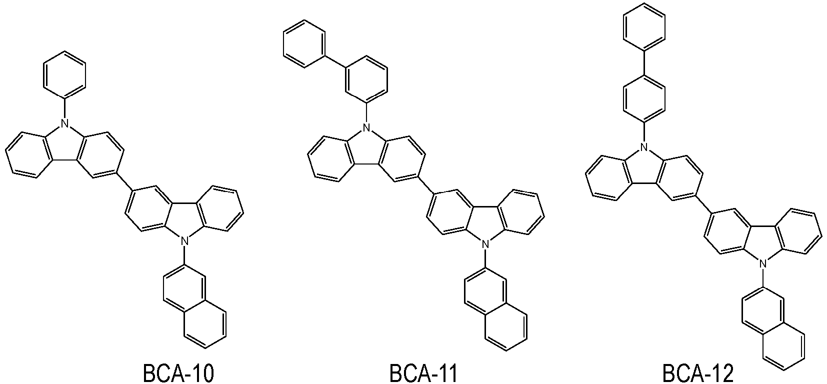

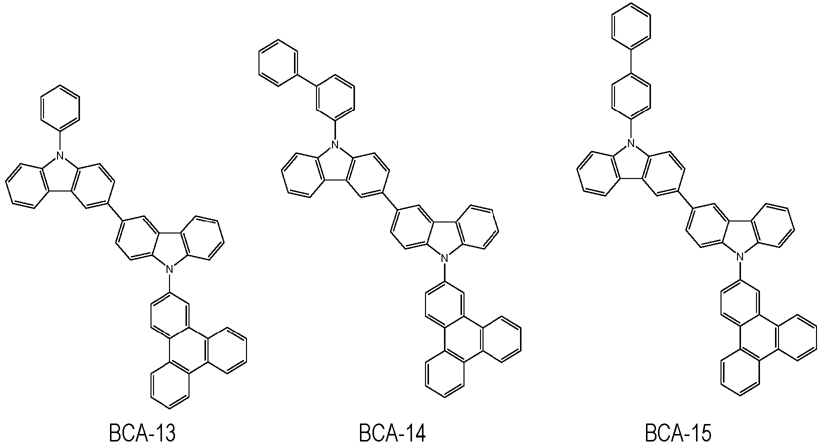

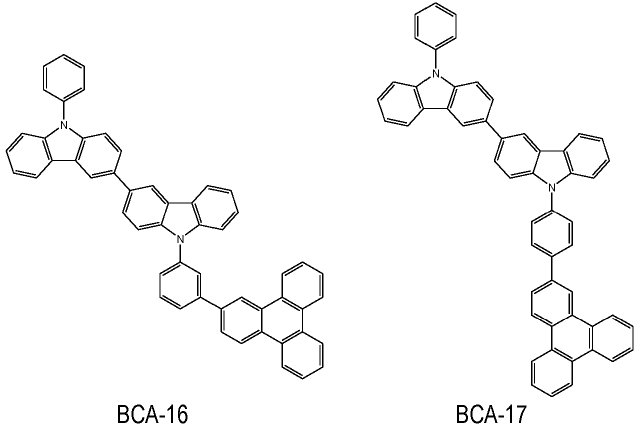

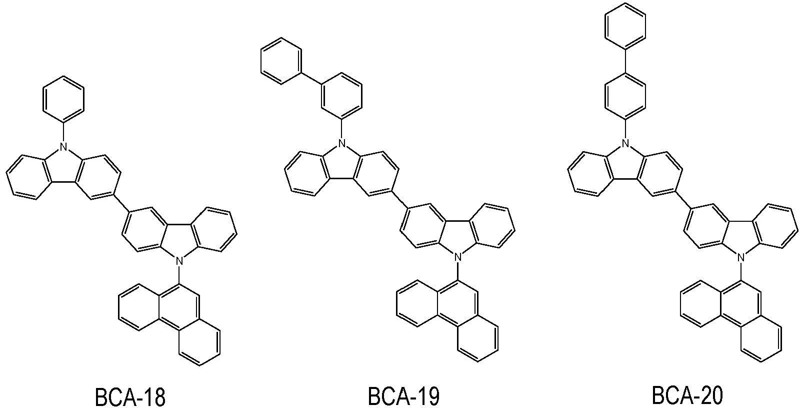

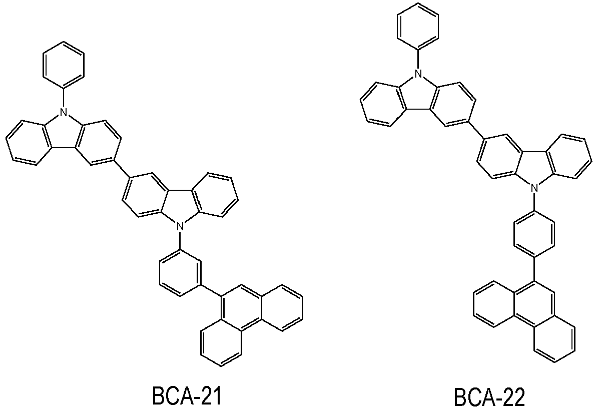

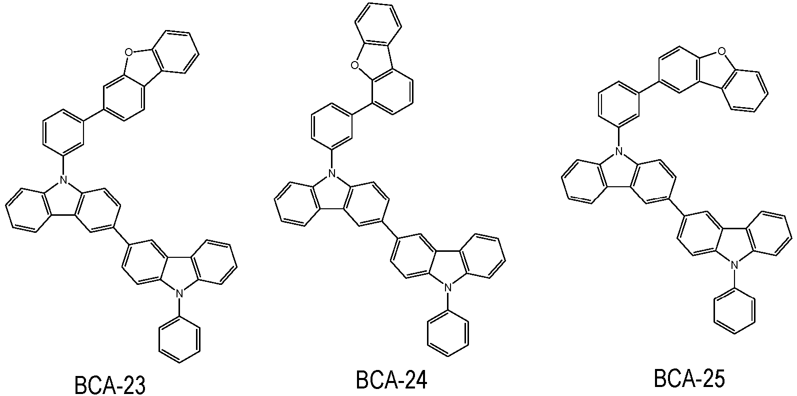

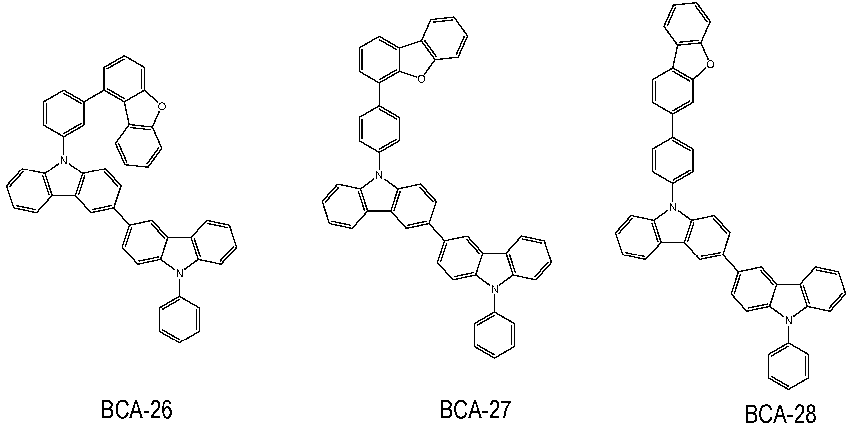

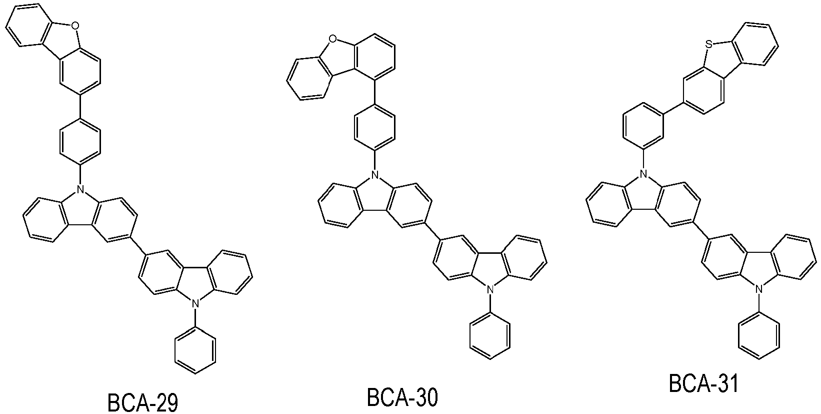

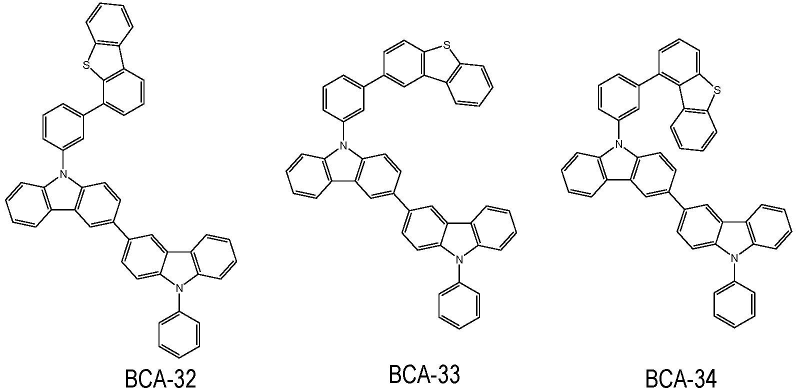

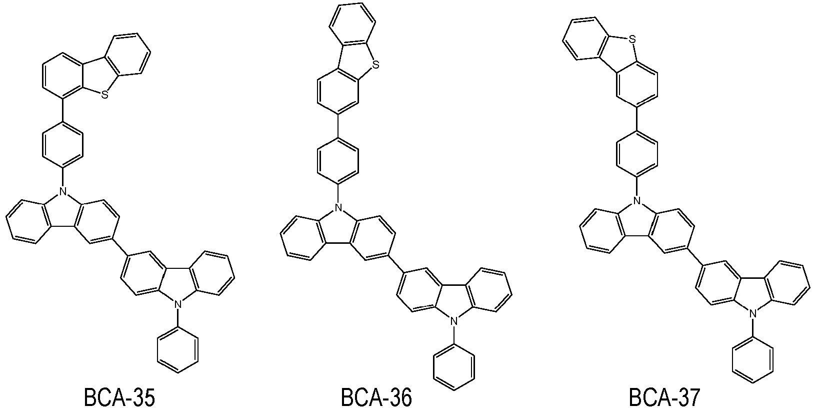

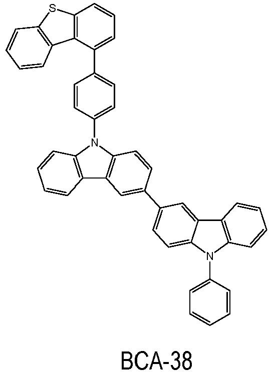

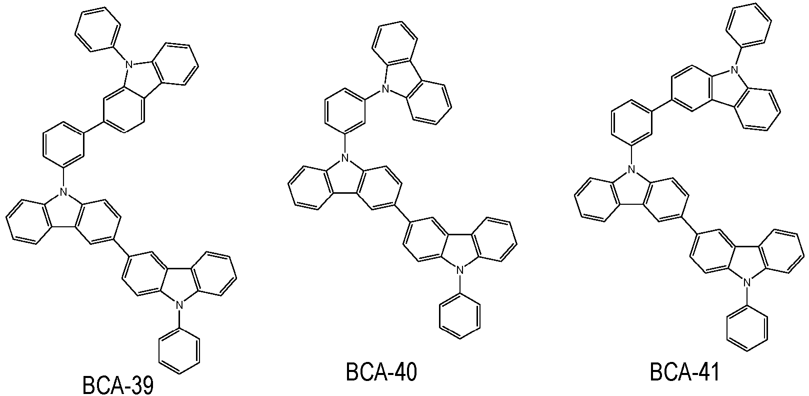

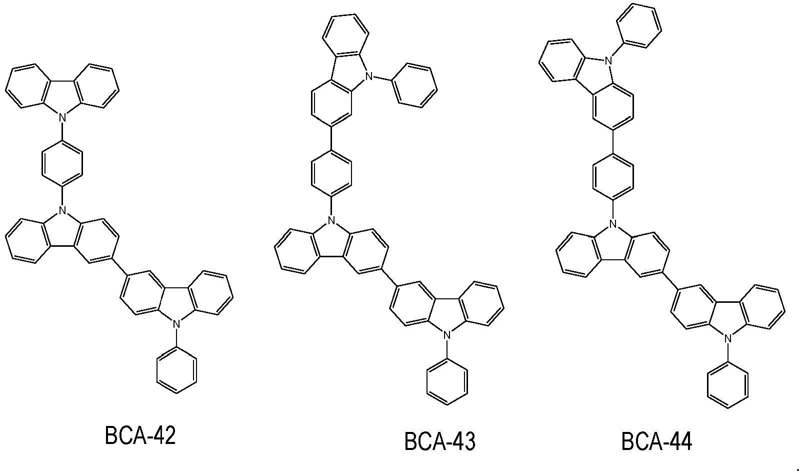

5. Dispositif électroluminescent selon l'une quelconque des revendications 1 à 4, dans lequel le dopant phosphorescent est un composé de complexe métallique ayant un pic d'émission d'une longueur d'onde de 510 nm à 550 nm.

6. Dispositif électroluminescent selon l'une quelconque des revendications 1 à 5, dans lequel un côté de la couche d'émission de lumière verte (1220) qui n'est pas en contact avec la couche de transport de trous (1210) est en contact avec une couche de transport d'électrons (1230).

7. Dispositif électroluminescent selon l'une quelconque des revendications 1 à 6, dans lequel un côté de la couche de transport d'électrons (1230) qui n'est pas en contact avec la couche d'émission de lumière verte (1220) est en contact avec une couche d'injection d'électrons ou une couche de génération de charges de type n.

8. Dispositif électroluminescent selon la revendication 7, dans lequel une couche organique dopée avec un métal ou une couche inorganique contenant un composé métallique est en contact avec le côté de la couche de transport d'électrons (1230) qui n'est pas en contact avec la couche d'émission de lumière verte (1220).

9. Dispositif électroluminescent selon la revendication 7, dans lequel au moins une couche parmi la couche de génération de charges de type p (1105) et de la couche de génération de charges de type n est adjacente à une pile bleue incluant une couche d'émission de lumière bleue, et
la couche d'émission de lumière bleue comporte un dopant bleu ayant un pic d'émission d'une longueur d'onde de 420 nm à 480 nm.

10. Dispositif électroluminescent selon l'une quelconque des revendications 1 à 9, dans lequel la couche de génération de charges de type p (1105) est espacée d'une distance de 50 nm ou plus de la première électrode.

11. Dispositif électroluminescent selon l'une quelconque des revendications 1 à 8 et 10, comportant en outre
une pile rouge, une première pile bleue et une seconde pile bleue disposées séquentiellement entre la première électrode et la seconde électrode,
dans lequel l'unité électroluminescente se trouve entre la première pile bleue et la seconde pile bleue.

12. Dispositif d'affichage électroluminescent comportant :
un substrat (100) comportant une pluralité de sous-pixels ;
un transistor à couches minces prévu sur chacun des sous-pixels sur le substrat ; et
le dispositif électroluminescent selon l'une quelconque des revendications 1 à 11, connecté au transistor à couches minces.
